# EUROPEAN PATENT SPECIFICATION

(11) **EP 4 571 459 B1**
(45) Date of publication and mention of the grant of the patent: **30.09.2026**
(21) Application number: 23924903.0
(22) Date of filing: 12.09.2023
(51) Int. Cl.: G06F 1/20, G06F 1/16

(54) **FOLDABLE ELECTRONIC DEVICE**
FALTBARE ELEKTRONISCHE VORRICHTUNG
DISPOSITIF ÉLECTRONIQUE PLIABLE

(30) Priority: 27.02.2023 CN 202310227579
(43) Date of publication of application: 18.06.2025
(73) Proprietor: Huawei Technologies Co., Ltd., Shenzhen, Guangdong 518129 (CN)
(72) Inventor: ZOU, Liujun, Shenzhen, Guangdong 518129 (CN); LIU, Tao, Shenzhen, Guangdong 518129 (CN)
(74) Representative: MERH-IP Matias Erny Reichl Hoffmann Patentanwälte PartG mbB
(86) International application number: PCT/CN2023/118385
(87) International publication number: WO 2024/178948

(56) References cited:
- WO-A1-2022/065861
- CN-A- 106 817 877
- CN-A- 109 901 687
- CN-A- 111 414 062
- CN-A- 113 839 441
- CN-U- 210 983 149
- US-A1- 2018 284 858
- US-B1- 11 314 297

## Description

### TECHNICAL FIELD

This application relates to the field of electronic device technologies, and in particular, to a foldable electronic device.

### BACKGROUND

A notebook computer has advantages such as light weight, a small size after folding, and good portability, and becomes increasingly popular with consumers. Currently, the notebook computer is an electronic consumer product widely used in modern digital office, teaching, gaming, and entertainment, and has become one of important productivity tools in the modern internet information era.

The notebook computer is used as an example. The foldable electronic device mainly includes a first housing, a second housing, and a rotating mechanism located between the first housing and the second housing. The first housing can rotatably cooperate with the second housing via the rotating mechanism, so that the first housing and the second housing can rotate relative to each other, and the first housing and the second housing can be folded or unfolded relative to each other. The first housing may have a button, a touch area, and the like to form a keyboard end. The second housing may have a display to form a display end. Main heat emitting elements such as a processing chip, a battery, and a circuit board of the notebook computer are all located in the first housing, an air intake vent and an air exhaust vent may be formed on the first housing, and a fan structure may be disposed in the first housing. To implement lightness and thinness of the notebook computer, the air exhaust vent is usually directly opposite to the rotating mechanism. Under an action of a fan, cold air enters from the air intake vent and exchanges heat with the heat emitting element, and then hot air is exhausted from the air exhaust vent, to achieve heat dissipation effect.

However, because the rotating mechanism is directly opposite to the air exhaust vent, heat dissipation and air exhausting are affected due to blocking. This is not conducive to heat dissipation, and reduces heat dissipation effect of the electronic device.

Document US 11 314 297 B1 generally discloses a portable electronic device. The portable electronic device may include a laptop computing device that includes a base portion and a display housing rotationally coupled to the base portion. The base portion includes a fan designed to drive heated air out of the base portion, thus cooling the portable electronic device. A dynamic (movable) air diverter is integrated into the base portion near the fan's outlet. The air diverter is designed to direct airflow from the fan outlet. Moreover, the air diverter can be repositioned by, for example, rotating the display housing relative to the base portion. As a result of the repositioned air diverter, the airflow from the fan outlet is redirected out of the portable electronic device through a different location. The air diverter can be positioned in different discrete locations, or alternatively, can move continuously with the rotational movement of the display housing.

Document US 2018/284858 A1 generally discloses thermal management devices and systems, and corresponding methods of cooling a computing device. The computing device includes a housing and an airflow management device. The housing includes a plurality of vents. The plurality of vents defines openings through the housing, respectively. The airflow management device is configured to block a first vent of the plurality of vents when the computing device is in a first configuration. The airflow management device is also configured to block a second vent of the plurality of vents when the computing device is in a second configuration.

Document CN 106 817 877 A generally discloses an electronic device that includes a display part, a pedestal, a movable housing and a transmission part, wherein the display part includes a rotating shaft part; the pedestal is in pin joint with the rotating shaft part, and is provided with an opening; the movable housing is in pin joint with the pedestal, and is configured to open or close the opening; the transmission part is arranged on the pedestal, and is connected with the rotating shaft part and the movable housing in an operable way; when the display part rotates, being far away from the pedestal, the rotating shaft part drives the movable housing through the transmission part so as to enable the movable housing to rotate and open the opening; and when the display part rotates to the pedestal, the rotating shaft part drives the movable housing through the transmission part to enable the movable housing to rotate and close the opening.

### SUMMARY

Embodiments of this application provide a foldable electronic device, to resolve a problem of poor heat dissipation effect of an existing electronic device. In particular, this application provides a foldable electronic device according to claim 1. The dependent claims relate to preferred embodiments.

An embodiment of this application provides a foldable electronic device, including a rotating mechanism, and a first housing and a second housing that are respectively located on two sides of the rotating mechanism. The first housing rotatably cooperates with the second housing via the rotating mechanism, to fold and unfold the electronic device.

The electronic device further includes a fan structure, an air exhaust structure, and an air deflection mechanism. The fan structure is located in the first housing, the air exhaust structure is disposed on the first housing, the air exhaust structure has an air exhaust vent, and the air exhaust vent faces the rotating mechanism. Hot air obtained after heat exchange in the first housing can be exhausted from the air exhaust vent, to dissipate heat for the electronic device.

The air deflection structure is movably disposed on the first housing, the air deflection structure blocks a partial area of the air exhaust vent, and an unblocked area of the air exhaust vent is used to form an air exhaust channel. The air deflection structure has a deflection function. The air deflection structure may make the air exhaust channel avoid the rotating mechanism, to change an air exhaust position and an air exhaust direction of hot air, so that hot air can avoid blocking impact of the rotating mechanism or the like and be exhausted out of a chamber. This reduces or avoids an air exhaust resistance generated by blocking, can reduce or avoid a problem of internal heating and temperature rise caused by hot air reflow due to blocking, and significantly improves heat dissipation effect. In addition, the air deflection structure is movably disposed on the first housing. In a rotation process of the rotating mechanism, the air deflection structure moves at the air exhaust vent to adjust the air exhaust channel of the air exhaust vent. A position of the air exhaust channel may be adjusted based on different impact of the rotating mechanism on air exhausting in unfolding and folding processes of the electronic device, to ensure that the air exhaust channel can well avoid the rotating mechanism when the electronic device is in different states, so that the electronic device has good heat dissipation effect in different states. This improves overall heat dissipation effect of the electronic device.

In a possible implementation, a linkage mechanism is further included. The linkage mechanism cooperates with both the air deflection structure and the rotating mechanism. When rotating, the rotating mechanism drives, via the linkage mechanism, the air deflection structure to move. The manner of linkage can facilitate control of movement of the air deflection structure, and reduce disposing of a driving mechanism. In this way, energy consumption and costs are reduced.

In a possible implementation, the first housing includes an upper housing and a lower housing. When the electronic device is in a closed state, the upper housing is disposed facing the second housing.

When the electronic device is in the closed state, the air deflection structure is at a first position, the air deflection structure blocks a first area of the air exhaust vent, and the first area is located on a side that is of the air exhaust vent and that faces the upper housing. When the electronic device is in the closed state, the rotating mechanism has severe blocking impact on air exhausting in the first area of the air exhaust vent, so that the air deflection structure is at the first position to block the first area of the air exhaust vent, and the remaining area of the air exhaust vent is used to form a lower air exhaust channel, and hot air can be smoothly exhausted from the lower air exhaust channel. This avoids blocking impact of the rotating mechanism.

When the electronic device is in an open state, the air deflection structure is at a second position, the air deflection structure blocks a second area of the air exhaust vent, and the second area is located on a side that is of the air exhaust vent and that faces the lower housing. When the electronic device is in the open state, the rotating mechanism has severe blocking impact on air exhausting in the second area of the air exhaust vent, so that the air deflection structure moves to the second position to block the second area of the air exhaust vent, and the remaining area of the air exhaust vent is used to form an upper air exhaust channel, and hot air can be smoothly exhausted from the upper air exhaust channel. This avoids blocking impact of the rotating mechanism.

In a process in which the electronic device rotates from the closed state to the open state, the air deflection structure moves from the first position to the second position, and the air deflection structure blocks at least a part of a third area of the air exhaust vent, where the third area is located between the first area and the second area. In a process in which the electronic device is in an intermediate state, blocking impact of the rotating mechanism on the first area and the second area of the air exhaust vent gradually decreases, so that the air deflection structure blocks at least a part of the third area, at least a part of the first area of the air exhaust vent may be used to form an upper air exhaust channel, at least a part of the second area of the air exhaust vent may be used to form a lower air exhaust channel, and hot air can be smoothly exhausted from both the upper air exhaust channel and the lower air exhaust channel. This avoids blocking impact of the rotating mechanism.

In a possible implementation, in a process in which the electronic device rotates from the closed state to a first intermediate state, the air deflection structure is at the first position. In a process in which the electronic device rotates from the first intermediate state to the open state, the air deflection structure moves from the first position to the second position. A movement manner of the air deflection structure is appropriately controlled based on blocking statuses of the air exhaust vent in different states of the electronic device. This helps reduce movement driving energy consumption of the air deflection structure while ensuring that blocking impact of the rotating mechanism on air exhausting can be reduced or avoided, and enriches a movement mode of the air deflection structure.

In a possible implementation, the air deflection structure is slidably disposed on the first housing, and the air deflection structure slides in a first direction, for the air deflection structure to move from the first position to the second position, where the first direction is an extension direction from the upper housing to the lower housing. In other words, in the process in which the electronic device is unfolded from the closed state to the open state, the air deflection structure slides in the first direction, to move between the first position and the second position, so as to adjust the air exhaust channel. A design of the movement manner is simple, and is easy to implement.

In a possible implementation, the rotating mechanism includes a rotating shaft, the rotating shaft is fastened to the second housing, and the rotating shaft rotatably cooperates with the first housing.

The linkage mechanism includes a first connecting rod, a first end of the first connecting rod is rotatably disposed on the first housing, and the first connecting rod rotates around a direction parallel to an axis of the rotating mechanism. The first end of the first connecting rod is configured to cooperate with the rotating shaft, and the second end of the first connecting rod cooperates with the air deflection structure. The rotating shaft rotates to drive the first end of the first connecting rod to rotate around the axis relative to the first housing, and the second end of the first connecting rod drives the air deflection structure to slide in the first direction, so that the air deflection structure can be at different positions, to block different areas of the air exhaust vent, so as to adjust the air exhaust channel. In addition, the first connecting rod rotates to drive the air deflection structure to slide. This helps increase a movable stroke of the air deflection structure, expand a position adjustment range of the air deflection structure, and enrich an applicable scenario of the air deflection structure.

**In** a possible implementation, the second end of the first connecting rod slidably cooperates with the air deflection structure, and the second end of the first connecting rod slides relative to the air deflection structure in a second direction, where the second direction is perpendicular to the first direction and the axis of the rotating mechanism. The first end of the first connecting rod rotates to drive the second end of the first connecting rod to move along an arc-shaped track, for the second end of the first connecting rod to slide relative to the air deflection structure in the second direction. **In** this way, a movement component of the arc-shaped movement track at the second end of the first connecting rod in the second direction is released. A component of the arc-shaped movement track at the second end of the first connecting rod in the first direction acts on the air deflection structure, so that the second end of the first connecting rod can drive the air deflection structure to slide relative to the first housing in the first direction.

**In** a possible implementation, one of the air deflection structure and the first connecting rod has a first guide rail, the other one of the air deflection structure and the first connecting rod has a first sliding member, the first guide rail extends in the second direction, and the first sliding member is slidably disposed along the first guide rail. In this way, it is ensured that the air deflection structure and the first connecting rod can slide relative to each other in the second direction.

One of the air deflection structure and the first housing has a second guide rail, the other one of the air deflection structure and the first housing has a second sliding member, the second guide rail extends in the first direction, and the second sliding member is slidably disposed along the second guide rail. This ensures that the air deflection structure and the first housing slide relative to each other in the first direction.

When the first housing and the second housing rotate relative to each other, the rotating shaft rotates to drive the first end of the first connecting rod to rotate, so that the second end of the first connecting rod slides relative to the first guide rail. In addition, the second end of the first connecting rod can drive the second sliding member of the air deflection structure to slide relative to a second guide rail member, so that the air deflection structure can slide in the first direction. In this way, a structure is simple, and is easy to implement.

In a possible implementation, the first housing further includes a first assembly frame, the rotating shaft and the first connecting rod separately rotatably cooperate with the first assembly frame, and the first assembly frame has a second guide rail. The first connecting rod, the rotating shaft, the air deflection structure, and the like may be first fastened to the first assembly frame, and then assembled to the first housing as a whole via the first assembly frame. This facilitates assembly of the air deflection structure and the like, and helps improve assembly efficiency.

In a possible implementation, at least a part of a periphery of the rotating shaft has a first tooth structure, the first end of the first connecting rod has a second tooth structure, and the first tooth structure is engaged and cooperates with the second tooth structure, so that when rotating, the rotating shaft can drive the first end of the first connecting rod to rotate, to implement linkage between the rotating shaft and both the first connecting rod and the air deflection structure. In addition, a cooperation manner of engaging via the tooth structures can further facilitate reset of the air deflection structure, and meet a position movement requirement of the air deflection structure in a case in which the electronic device is switched between the closed state and the open state.

In a possible implementation, the first tooth structure is disposed around the part of the periphery of the rotating shaft. In a process in which the rotating shaft rotates for one cycle, the second tooth structure is engaged with the first tooth structure in only a part of a rotation track, to drive the air deflection structure to move. However, the second tooth structure is not engaged with the first tooth structure in a part of the rotation track, and the air deflection structure does not move. For example, in the process in which the electronic device rotates from the closed state to the first intermediate state, the first tooth structure of the rotating shaft is not engaged with the second tooth structure on the first connecting rod, and the air deflection structure may always remain at the first position. The first tooth structure is engaged with the second tooth structure in only the process in which the electronic device rotates from the first intermediate state to the open state. The air deflection structure moves in a rotation process of the rotating shaft, to move from the first position to the second position. This meets a requirement that the air deflection structure does not move in the process in which the electronic device rotates from the closed state to the first intermediate state.

In a possible implementation, an end part of an end of the air deflection structure forms a rotating end, the rotating end is rotatably disposed on the first housing, and the air deflection structure is rotatably disposed around a direction parallel to an axis of the rotating mechanism via the rotating end, for the air deflection structure to move from the first position to the second position. In other words, the air deflection structure rotates around the rotating end of the air deflection structure. In the rotation process of the rotating mechanism, the air deflection structure moves along an arc-shaped track with the rotating end as a center, so that the air deflection structure moves between the first position and the second position, to adjust the air exhaust channel. This enriches a movement implementation of the air deflection structure, and helps extend an applicable scenario of the air deflection structure.

In a possible implementation, the rotating mechanism includes a rotating shaft, the rotating shaft is fastened to the second housing, and the rotating shaft rotatably cooperates with the first housing.

The linkage mechanism includes a second connecting rod, the second connecting rod is slidably disposed on the first housing, the second connecting rod slides in a second direction, and the second direction is perpendicular to the axis. A first end of the second connecting rod cooperates with the rotating shaft, and a second end of the second connecting rod cooperates with the rotating end. The rotating shaft rotates to drive the second connecting rod to move in the second direction, and the second connecting rod drives the rotating end to rotate around the axis, for the air deflection structure to move between the first position and the second position, to block different areas of the air exhaust vent, so as to adjust the air exhaust channel. In this way, a structure design is simpler, and is easy to implement.

In a possible implementation, the rotating end slidably cooperates with the second end of the second connecting rod, the rotating end slides relative to the second connecting rod in a first direction, and the first direction is perpendicular to the second direction and the axis. When the second connecting rod slides in the second direction, the second connecting rod and the rotating end of the air deflection structure slide relative to each other in the first direction. In this way, when the rotating end and the second connecting rod slide relative to each other in the first direction, the rotating end also slides with the second connecting rod in the second direction. In this case, the rotating end is driven to rotate relative to the first housing, for the air deflection structure to move between the first position and the second position. In this way, a movement manner is simple in design, and is easy to implement during production.

In a possible implementation, one of the rotating end and the second connecting rod has a third guide rail, the other one of the rotating end and the second connecting rod has a third sliding member, the third guide rail extends in the first direction, and the third sliding member is slidably disposed along the third guide rail. This ensures that the air deflection structure and the second connecting rod slide relative to each other in the first direction.

One of the second connecting rod and the first housing has a fourth guide rail, the other one of the second connecting rod and the first housing has a fourth sliding member, the fourth guide rail extends in the second direction, and the fourth sliding member is slidably disposed along the fourth guide rail. This ensured that the second connecting rod and the first housing slide relative to each other in the second direction.

When the first housing and the second housing rotate relative to each other, the rotating shaft rotates to drive the fourth guide rail and the fourth sliding member to slide relative to each other, so that the third guide rail on the second connecting rod and the third sliding member on the rotating end slide relative to each other in the first direction, to drive the rotating end to rotate around the direction parallel to the axis, so as to adjust a position of the air deflection structure.

In a possible implementation, the first housing further includes a second assembly frame, the air deflection structure rotatably cooperates with the second assembly frame, and the second assembly frame has the fourth sliding member. This facilitates assembly of the air deflection structure and the like on the first housing, and helps improve assembly efficiency.

In a possible implementation, the rotating shaft has a first limiting structure, the second connecting rod has a second limiting structure, and the first limiting structure is configured to abut against and cooperate with the second limiting structure, so that when rotating, the rotating shaft can drive the second connecting rod to move in the second direction. In this way, a structure design is simple, and is easy to implement. This helps reduce costs.

In a possible implementation, the periphery of the rotating shaft has a protrusion member to form the first limiting structure, and the second connecting rod has an arc-shaped groove to form the second limiting structure. In the process in which the electronic device rotates from the closed state to the first intermediate state, the first limiting structure may slide relative to the second limiting structure, and the first limiting structure does not abut against and cooperate with the second limiting structure. In the process in which the electronic device rotates from the first intermediate state to the open state, the first limiting structure may abut against and cooperate with the bottom end of the second limiting structure, and the air deflection structure rotates around the rotating end in the rotation process of the rotating shaft, to move from the first position to the second position. This can also meet the requirement that the air deflection structure does not move in the process in which the electronic device rotates from the closed state to the first intermediate state.

In a possible implementation, the linkage mechanism further includes an elastic member, one end of the elastic member is connected to the first housing, and the other end of the elastic member is connected to the second connecting rod. In a process in which the electronic device rotates from the open state to the closed state, the elastic member is configured to drive the second connecting rod to slide in a direction opposite to the second direction, for the air deflection structure to move from the second position to the first position. In other words, reset movement of the second connecting rod is implemented via the elastic member in a folding process of the electronic device, to reset the air deflection structure. This meets a position movement requirement of the air deflection structure in a case in which the electronic device is switched between the closed state and the open state.

In a possible implementation, the air deflection structure is disposed across the air exhaust structure, a first end that is of the air deflection structure and that is along the axis of the rotating mechanism movably cooperates with the first end of the air exhaust structure, a second end that is of the air deflection structure and that is along the axis extends out of the second end of the air exhaust structure, and the second end of the air deflection structure is connected to the linkage mechanism. In other words, only one end of the air deflection structure is connected to the linkage mechanism, and the other end of the air deflection structure is movably connected to the air exhaust structure. This can reduce disposing of the linkage mechanism while ensuring movement stability of the air deflection structure. In this way, a structure is simplified, and costs are reduced. In addition, the air deflection structure is disposed across the air exhaust structure, to ensure movement stability of the air deflection structure, and no additional assembly fastener needs to be disposed. This helps simplify an overall structure and reduce costs.

In a possible implementation, a fastening bracket is further included. The fastening bracket is fastened to the first housing, the first end that is of the air deflection structure and that is along the axis of the rotating mechanism movably cooperates with the fastening bracket, and the second end that is of the air deflection structure and that is along the axis is connected to the linkage mechanism. Stable assembly of the air deflection structure is implemented via the independent fastening bracket. This simplifies design difficulty of the air deflection structure, the air exhaust structure, and the like, and facilitates implementation.

In a possible implementation, an airflow channel is formed on the air exhaust structure, an air exhaust vent is formed on a surface that is of the airflow channel and that faces the rotating mechanism, and the air deflection structure is located on a side that is of the airflow channel and that is opposite to the rotating mechanism.

Alternatively, the air deflection structure partially extends into the airflow channel. This helps reduce overall space occupied by the air deflection structure and the air exhaust structure, and improve a structural layout inside the first housing. In addition, an assembly design manner of the air deflection structure is enriched, to meet a requirement in a wider structural scenario.

In a possible implementation, the air deflection structure includes an air deflection unit, and the air deflection unit is opposite to the air exhaust vent. The air deflection unit has a first deflection slope and a second deflection slope that are opposite to each other, and the first deflection slope and the second deflection slope extend obliquely opposite to each other along an end that is of the air deflection unit and that is opposite to the rotating mechanism to an end that is of the air deflection unit and that faces the rotating mechanism. The first deflection slope and the second deflection slope that extend obliquely can improve deflection performance of the air deflection structure, and help change the air exhaust direction, so that after being deflected by the air deflection structure, hot air avoids the rotating mechanism and is smoothly exhausted from the air exhaust vent.

In a possible implementation, a cross-sectional shape of the air deflection unit in a direction perpendicular to the axis of the rotating mechanism includes a triangle. This can ensure good deflection effect, help reduce complexity of a mold for molding, and facilitate machining implementation.

In a possible implementation, a heat dissipation structure located in the first housing is further included, and the heat dissipation structure is located between the fan structure and the air exhaust vent. The heat dissipation structure is configured to connect to a heat emitting element in the first housing, and the fan structure is configured to facilitate flowing of air in a chamber, so that cold air in an environment enters the first housing, exchanges heat with the heat dissipation structure, and then is exhausted from the air exhaust vent. This improves heat dissipation effect.

In a possible implementation, the electronic device further includes a display, the display is located on the second housing, and the display may be used to display an image and the like.

The electronic device further includes a button structure. The button structure is located on the first housing. The button structure may be configured to recognize operation information of a user, to implement a function like human-computer interaction with the user.

### BRIEF DESCRIPTION OF DRAWINGS

FIG. 1 is a diagram of a structure of an electronic device in a closed state according to an embodiment of this application;
FIG. 2 is a diagram of a structure of an electronic device in an intermediate state according to an embodiment of this application;
FIG. 3 is a diagram of a structure of an electronic device in an open state according to an embodiment of this application;
FIG. 4 is a diagram of a cross-sectional partial structure of an electronic device in a first intermediate state in a related technology;
FIG. 5 is a diagram of a cross-sectional partial structure of an electronic device in an open state in a related technology;
FIG. 6 is a diagram of a cross section of an electronic device according to an embodiment of this application;
FIG. 7 is a diagram of a cross section of an electronic device in a closed state according to an embodiment of this application;
FIG. 8 is a diagram of a cross section of an electronic device in an open state according to an embodiment of this application;
FIG. 9 is a diagram of a cross section of an electronic device in a first intermediate state according to an embodiment of this application;
FIG. 10 is a diagram of a cross section of an electronic device in a second intermediate state according to an embodiment of this application;
FIG. 11 is a diagram of linkage driving of an air deflection structure in an electronic device according to an embodiment of this application;
FIG. 12 is a diagram of assembly of a rotating mechanism, a linkage mechanism, and an air deflection structure in an electronic device according to an embodiment of this application;
FIG. 13 is a diagram of splitting of a rotating mechanism, a linkage mechanism, and an air deflection structure in an electronic device according to an embodiment of this application;
FIG. 14 is a diagram of a cross-sectional structure of an electronic device in a closed state according to an embodiment of this application;
FIG. 15 is a diagram of assembly of an air deflection structure, a linkage mechanism, and an air exhaust structure in a case in which an electronic device is in a closed state according to an embodiment of this application;
FIG. 16 is a diagram of a cross-sectional structure of an electronic device in a first intermediate state according to an embodiment of this application;
FIG. 17 is a diagram of assembly of an air deflection structure, a linkage mechanism, and an air exhaust structure in a case in which an electronic device is in a first intermediate state according to an embodiment of this application;
FIG. 18 is a diagram of a cross-sectional structure of an electronic device in a second intermediate state according to an embodiment of this application;
FIG. 19 is a diagram of assembly of an air deflection structure, a linkage mechanism, and an air exhaust structure in a case in which an electronic device is in a second intermediate state according to an embodiment of this application;
FIG. 20 is a diagram of a cross-sectional structure of an electronic device in an open state according to an embodiment of this application;
FIG. 21 is a diagram of assembly of an air deflection structure, a linkage mechanism, and an air exhaust structure in a case in which an electronic device is in an open state according to an embodiment of this application;
FIG. 22 is a diagram of another cross section of an electronic device according to an embodiment of this application;
FIG. 23 is a diagram of another cross section of an electronic device in a closed state according to an embodiment of this application;
FIG. 24 is a diagram of another cross section of an electronic device in a first intermediate state according to an embodiment of this application;
FIG. 25 is a diagram of another cross section of an electronic device in a second intermediate state according to an embodiment of this application;
FIG. 26 is a diagram of another cross section of an electronic device in an open state according to an embodiment of this application;
FIG. 27 is another diagram of linkage driving of an air deflection structure in an electronic device according to an embodiment of this application;
FIG. 28 is another diagram of assembly of a rotating shaft, a linkage mechanism, and an air deflection structure in an electronic device according to an embodiment of this application;
FIG. 29 is another diagram of splitting of a rotating shaft, a linkage mechanism, and an air deflection structure in an electronic device according to an embodiment of this application;
FIG. 30 is a diagram of another cross-sectional structure of an electronic device in a closed state according to an embodiment of this application;
FIG. 31 is another diagram of assembly of an air deflection structure, a linkage mechanism, and an air exhaust structure in a case in which an electronic device is in a closed state according to an embodiment of this application;
FIG. 32 is a diagram of another cross-sectional structure of an electronic device in a first intermediate state according to an embodiment of this application;
FIG. 33 is another diagram of assembly of an air deflection structure, a linkage mechanism, and an air exhaust structure in a case in which an electronic device is in a first intermediate state according to an embodiment of this application;
FIG. 34 is a diagram of another cross-sectional structure of an electronic device in a second intermediate state according to an embodiment of this application;
FIG. 35 is another diagram of assembly of an air deflection structure, a linkage mechanism, and an air exhaust structure in a case in which an electronic device is in a second intermediate state according to an embodiment of this application;
FIG. 36 is a diagram of another cross-sectional structure of an electronic device in an open state according to an embodiment of this application; and
FIG. 37 is another diagram of assembly of an air deflection structure, a linkage mechanism, and an air exhaust structure in a case in which an electronic device is in an open state according to an embodiment of this application.

Reference numerals:
100: electronic device;
10: first housing; 10a: chamber; 11: upper housing; 12: lower housing;
20: second housing;
30: rotating mechanism; 31: rotating shaft; 311: first tooth structure; 312: first limiting structure; 32: bearing member; 33: first gear;
40: air exhaust structure; 40a: airflow channel; 41: air exhaust vent; 41a: first area; 41b: second area; 41c: third area; 44: alignment slot; 45: first avoidance groove;
50: air deflection structure; 50a: first deflection slope; 50b: second deflection slope; 50c: rotating end; 51: first guide rail; 52: second sliding member; 53: third sliding member; 54: air deflection unit; 55: extension part;
60: linkage mechanism;
   61: first connecting rod; 611: second tooth structure; 612: first sliding member; 62: rotating member;
   63: second connecting rod; 631: second limiting structure; 632: third guide rail; 633: fourth guide rail; 64: elastic member;
   70: first assembly frame; 71: second guide rail; 72: assembly hole;
   80: second assembly frame; 81: fourth sliding member;
   90: fastening bracket; 91: second avoidance groove;
   110: heat dissipation structure; and
   120: fan structure.

### DESCRIPTION OF EMBODIMENTS

Terms used in embodiments of this application are only used to explain specific embodiments of this application, but are not intended to limit this application.

The foldable electronic device provided in the embodiments of this application may include but is not limited to a foldable fixed terminal or mobile terminal such as a mobile phone, a tablet computer, a notebook computer, a foldable notebook computer, an ultra-mobile personal computer (ultra-mobile personal computer, UMPC for short), a handheld computer, a touch television, a walkie-talkie, a netbook, a POS terminal, a personal digital assistant (personal digital assistant, PDA for short), a wearable device, or a virtual reality device.

In embodiments of this application, an example in which the foldable electronic device is a notebook computer is used for description.

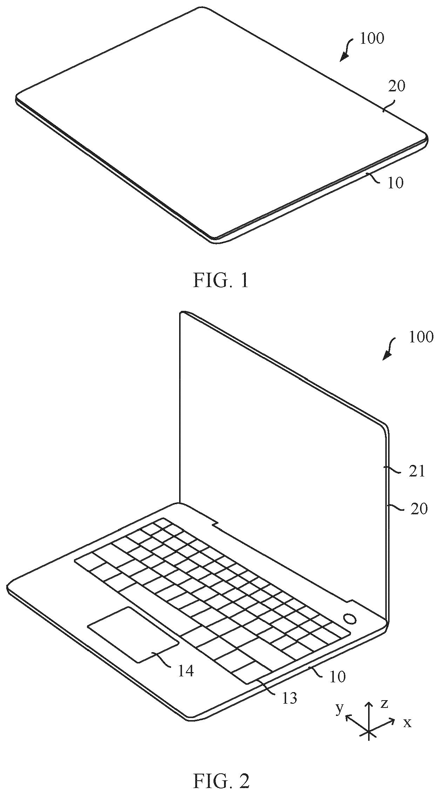

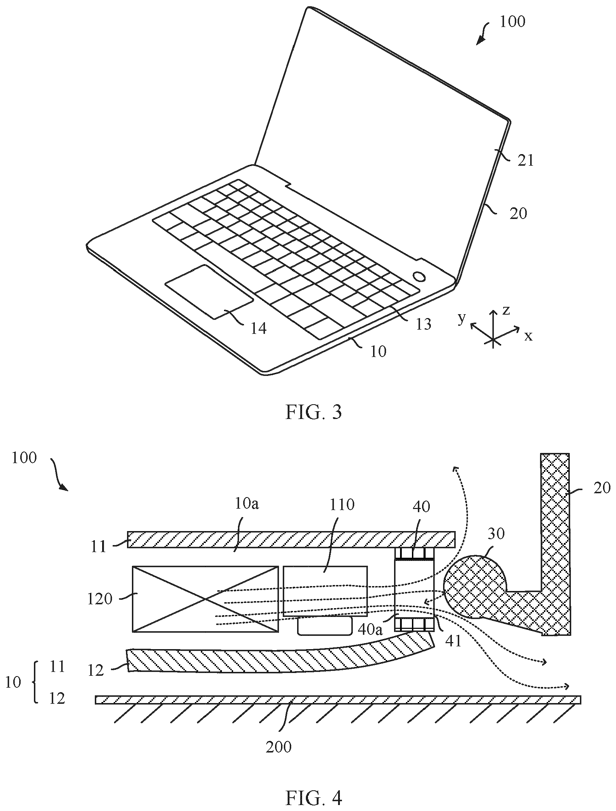

FIG. 1 is a diagram of a structure of an electronic device in a closed state according to an embodiment of this application. FIG. 2 is a diagram of a structure of the electronic device in an intermediate state according to an embodiment of this application. FIG. 3 is a diagram of a structure of the electronic device in an open state according to an embodiment of this application.

Refer to FIG. 1. An electronic device 100 may include two housings, for example, a first housing 10 and a second housing 20. The electronic device 100 may further include a rotating mechanism (not shown in the figure). The first housing 10 and the second housing 20 are respectively located on two sides of the rotating mechanism, the first housing 10 and the second housing 20 may be separately connected to the rotating mechanism, and the first housing and the second housing may be unfolded and folded via the rotating mechanism.

Refer to FIG. 3. In this embodiment of this application, a thickness direction of the first housing 10 is used as a first direction, for example, a z direction in the figure, a width direction of the first housing 10 is used as a second direction, for example, an x direction in the figure, and a length direction of the first housing 10 is used as a third direction, for example, a y direction in the figure. A length, a width, and a thickness in embodiments of this application are merely for ease of description, and do not mean any limitation on a size. For example, the length may be greater than, equal to, or less than the width.

The rotating mechanism may be a hinge structure, a rotating shaft structure, or the like. Rotational cooperation between the first housing 10 and the second housing 20 can be implemented via the rotating mechanism, and an axis of the rotating mechanism may be parallel to the third direction (the y direction). In this way, the first housing 10 and the second housing 20 can rotate relative to each other around the y direction.

Refer to FIG. 1. The first housing 10 and the second housing 20 can be folded relative to each other to a closed state. When the first housing 10 and the second housing 20 are in the closed state, the first housing 10 and the second housing 20 can be completely closed to be parallel to each other (a slight deviation is allowed). In this case, the electronic device 100 is in the closed state, which is also referred to as a folded state, and the electronic device 100 is folded in a two-layer form.

Refer to FIG. 2. The first housing 10 and the second housing 20 can rotate (be folded or unfolded) relative to each other to an intermediate state, so that the electronic device 100 is in the intermediate state.

As shown in FIG. 3, the first housing 10 and the second housing 20 can be unfolded relative to each other to an open state. When the first housing 10 and the second housing 20 are in the open state, the first housing 10 and the second housing 20 are fastened relative to each other and cannot continue to rotate. In this case, the electronic device 100 is in the open state, which is also referred to as an unfolded state. For example, when the electronic device 100 is in the open state, an angle between the first housing 10 and the second housing 20 may be approximately 135° (a slight deviation is allowed).

Certainly, in some other examples, when the electronic device 100 is in the open state, another angle may alternatively be maintained between the first housing 10 and the second housing 20. For example, the angle between the first housing 10 and the second housing 20 may be approximately 180°.

It should be understood that the intermediate state may be any state between the open state and the closed state. In other words, the electronic device 100 switches between the open state and the closed state through movement of the rotating mechanism. The electronic device 100 may have a plurality of intermediate states. For example, the electronic device 100 may have an intermediate state with a small unfolding angle. As shown in FIG. 2, the electronic device 100 may be in a first intermediate state, and the angle between the first housing 10 and the second housing 20 is approximately 90°. Alternatively, the electronic device 100 may have an intermediate state with a large unfolding angle. For example, the electronic device 100 may be in a second intermediate state, and the angle between the first housing 10 and the second housing 20 is approximately 110°.

Certainly, in some other examples, when the electronic device 100 is in the first intermediate state and the second intermediate state, another angle, for example, 75° or 115°, may alternatively be maintained between the first housing 10 and the second housing 20. A specific value may be selected and set based on an actual requirement.

It should be noted that the electronic device 100 may include only two housings. In other words, there may be one first housing 10, one rotating mechanism, and one second housing 20. The rotating mechanism may be located between the first housing 10 and the second housing 20. When the electronic device 100 is in the closed state, the first housing 10 and the second housing 20 are folded relative to each other to form a two-layer state (refer to FIG. 1).

Alternatively, the electronic device 100 may include a plurality of housings. In other words, there may be a plurality of first housings 10, a plurality of rotating mechanisms, and a plurality of second housings 20. The first housing 10 and the second housing 20 that are adjacent to each other may be connected via one rotating mechanism. When the electronic device 100 is in the closed state, the electronic device 100 may be folded into a multi-layer state. For example, the electronic device 100 may be a triple-fold foldable mobile phone. The electronic device 100 may include two first housings 10, two rotating mechanisms, and one second housing 20. The two first housings 10 are located on two sides of the second housing 20, and the two first housings 10 may be separately rotatably connected to the second housing 20 via one rotating mechanism. One first housing 10 may be folded relative to the second housing 20, and the other first housing 10 may also be folded relative to the second housing 20, so that when the electronic device 100 is in the closed state, the first housings 10 and the second housing 20 are folded relative to each other to form a three-layer form. When one of the first housings 10 is unfolded relative to the second housing 20 to the open state, the electronic device 100 is in the open state.

In this embodiment of this application, an example in which the electronic device 100 includes two housings is used for description.

With reference to FIG. 2 and FIG. 3, the electronic device 100 may further include a button structure 13. The button structure 13 may be disposed on the first housing 10. The button structure 13 may be configured to: recognize operation information of a user, implement human-computer interaction with the user, and the like. It should be understood that the button structure 13 may be a protruding button mechanical part, or the button structure 13 may be a virtual button, or the like.

The first housing 10 may further have a touch area 14, and the touch area 14 may also be used to recognize operation information of the user, for example, gesture information, to enrich operation experience on the electronic device 100.

The electronic device 100 may further include a display 21. The display 21 may be disposed on the second housing 20, and the display 21 is configured to display an image and the like.

Certainly, in some other examples, the display 21 may also be configured to recognize operation information of the user, for example, operation location information and gesture information of the user.

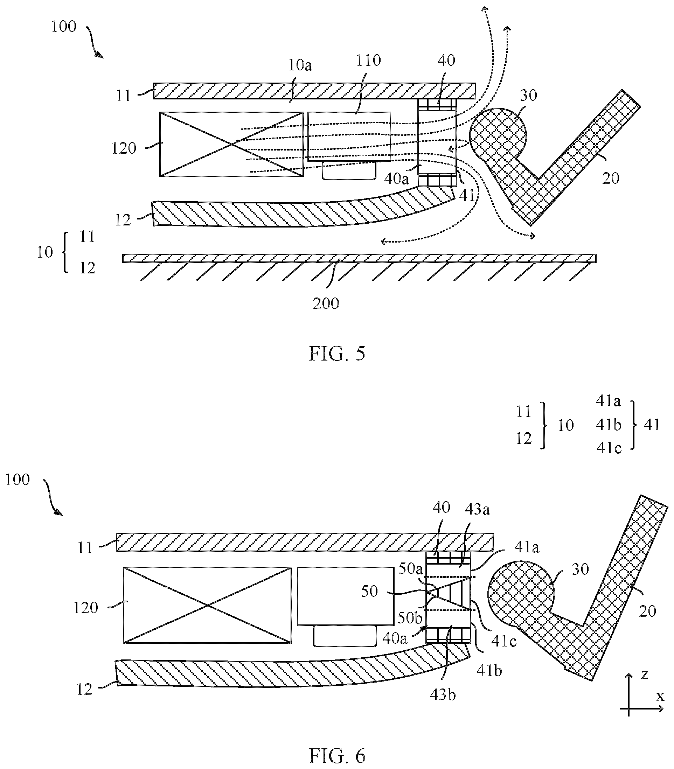

FIG. 4 is a diagram of a cross-sectional partial structure of the electronic device in the first intermediate state in a related technology. FIG. 5 is a diagram of a cross-sectional partial structure of the electronic device in the open state in a related technology.

Refer to FIG. 4. A rotating mechanism 30 may be fastened to the second housing 20, and the second housing 20 rotatably cooperates with the first housing 10 via the rotating mechanism 30.

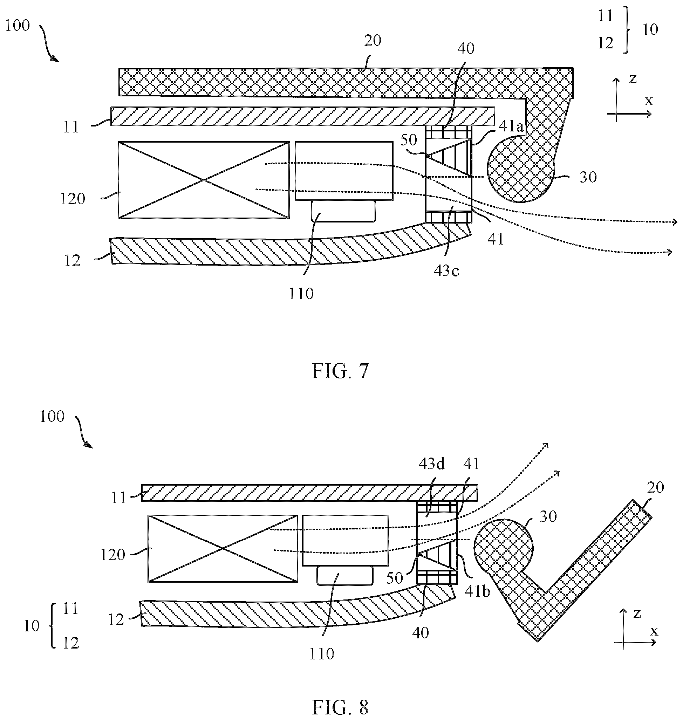

The first housing 10 may include an upper housing 11 and a lower housing 12. When the electronic device 100 is in the closed state, the upper housing 11 is disposed facing the second housing 20 (refer to FIG. 7). In other words, in the closed state, the upper housing 11 is disposed more adjacent to the second housing 20 than the lower housing 12.

Specifically, the upper housing 11 may cover the lower housing 12, a chamber 10a is formed between the upper housing 11 and the lower housing 12, and the button structure 13, the touch area 14, and the like may be disposed on the upper housing 11.

In some other examples, a display may also be disposed on the upper housing 11. For example, when the electronic device is a foldable mobile phone or a foldable notebook computer, a flexible display may be laid on the upper housing 11.

A display may also be disposed on the lower housing 12. For example, when the electronic device is a foldable mobile phone or a foldable notebook computer, a display may also be disposed on a side that is of the lower housing and that is opposite to the upper housing.

The electronic device 100 may further include structures such as a circuit board, a processing chip, and a battery. Such structures are main heat emitting elements of the electronic device 100 during working, and may be disposed in the chamber 10a of the first housing 10.

For heat dissipation of the electronic device 100, the electronic device 100 may further include a fan structure 120, a heat dissipation structure 110, and an air exhaust structure 40. The fan structure 120, the heat dissipation structure 110, and the air exhaust structure 40 may all be assembled on the first housing 10.

Both the heat dissipation structure 110 and the fan structure 120 may be located in the chamber 10a. The heat dissipation structure 110 may be a mechanical part formed by using a heat conducting material. For example, the heat conducting material may be one or more of metal, a heat pipe, a vapor chamber (Vapor Chamber, VC for short) uniform heat plate, graphite, and graphene. The heat dissipation structure 110 may be in thermal contact with the heat emitting element.

The heat dissipation structure 110 may be located between the fan structure 120 and the air exhaust structure 40. Still refer to FIG. 4. An airflow channel 40a may be formed on the air exhaust structure 40, the air exhaust structure 40 may further have an air exhaust vent 41, and the air exhaust vent 41 may be located on a surface that is of the airflow channel 40a and that faces the rotating mechanism 30. An air intake vent (not shown in the figure) may be further opened on the first housing 10 of the electronic device 100. The fan structure 120 is configured to facilitate flowing of air in the chamber 10a, so that cold air in an environment enters the chamber 10a from the air intake vent and forms hot air after heat exchange with the heat dissipation structure 110. Hot air is exhausted from the air exhaust vent 41 through the airflow channel 40a, to achieve heat dissipation effect.

Refer to FIG. 4. To meet a thinning requirement of the electronic device 100 and reduce space occupied by the air exhaust structure 40 and the like in the chamber 10a, the air exhaust structure 40 may be disposed between the upper housing 11 and the lower housing 12, the air exhaust structure 40 is disposed adjacent to the rotating mechanism 30, and the air exhaust vent 41 of the air exhaust structure 40 faces the rotating mechanism 30.

It should be noted that the air exhaust vent 41 may be opened on the first housing 10. For example, the first housing 10 may further include a middle housing (not shown in the figure). The middle housing may be located between the upper housing 11 and the lower housing 12, a part of the middle housing may be used as the air exhaust structure 40, and the air exhaust vent 41 may be formed on the part of the middle housing.

It should be understood that the middle housing and the lower housing 12 may be an integrated mechanical part, and the upper housing 11 may cover the middle housing, so that the upper housing 11, the middle housing, and the lower housing 12 jointly enclose the first housing 10 having the chamber 10a. Alternatively, the middle housing and the lower housing 12 may be an integrated mechanical part, and are jointly disposed on the lower housing 12, to form the first housing 10. Alternatively, the middle housing, the upper housing 11, and the lower housing 12 are independent mechanical parts, and are connected to enclose the first housing 10 having the chamber 10a.

Certainly, in some other examples, the air exhaust structure 40 may alternatively be a mechanical part independently disposed on the first housing 10. For example, the air exhaust structure 40 may be fastened to the lower housing 12, and the air exhaust structure 40 is located on a side that is in the chamber 10a and that is close to the rotating mechanism 30. An avoidance opening may be formed on the first housing 10, the avoidance opening is located between the upper housing 11 and the lower housing 12, and the avoidance opening may be opposite to the air exhaust vent 41, so that hot air exhausted from the air exhaust vent 41 enters the environment through the avoidance opening, to implement heat dissipation.

Still refer to FIG. 4. Because the air exhaust vent 41 faces the rotating mechanism 30, the rotating mechanism 30 and the second housing 20 (for example, a part at an end that is of the second housing 20 and that is fastened to the rotating mechanism 30) have blocking impact on air exhausting. Consequently, an air exhaust resistance is formed, and heat dissipation effect is affected. In addition, hot air is easily rebounded by the rotating mechanism 30 and flows back to the chamber 10a, resulting in a second internal temperature rise, and greatly reducing heat dissipation effect.

It may be understood that, in entire unfolding and folding processes in which the electronic device 100 is switched between the closed state and the unfolded state, impact of the rotating mechanism 30 on air exhausting changes due to different unfolding and folding degrees of the first housing 10 and the second housing 20. This causes different heat dissipation capabilities of the electronic device 100 in different states, and also affects heat dissipation effect of the electronic device 100.

For example, when the electronic device 100 is in the closed state, or when the electronic device 100 is in an intermediate state with a small unfolding angle, for example, an intermediate state in which the angle between the first housing 10 and the second housing 20 is approximately 0° to 90°, for example, the angle between the first housing 10 and the second housing 20 is approximately 90° as shown in FIG. 4, the rotating mechanism 30 has severer blocking impact on air exhausting at an upper end (an end adjacent to the upper housing 11) of the air exhaust vent 41, and forms a large resistance to air exhausting at the upper end of the air exhaust vent 41.

When the electronic device 100 is in the open state, or when the electronic device 100 is in an intermediate state with a large unfolding angle, for example, an intermediate state in which the angle between the first housing 10 and the second housing 20 is approximately 90° to 110°, for example, the angle between the first housing 10 and the second housing 20 is approximately 110° as shown in FIG. 5, the rotating mechanism 30 has severer blocking impact on air exhausting at a lower end (an end adjacent to the lower housing 12) of the air exhaust vent 41, and forms a large resistance to air exhausting at the lower end of the air exhaust vent 41. Consequently, a problem of rebound and reflow is also very likely to occur. In addition, blocking impact on the lower end of the air exhaust vent 41 easily causes a change in an air exhaust direction of hot air, so that hot air exhausted from the air exhaust vent 41 is easily rebounded to a lower part of the lower housing 12 on a tabletop 200 or the like. In this case, the first housing 10 is heated again. This reduces heat dissipation effect.

On this basis, an embodiment of this application provides an electronic device 100. An air exhaust position and an air exhaust direction of hot air at an air exhaust vent 41 are changed via an air deflection structure 50, to reduce or avoid blocking impact of the rotating mechanism 30 on air exhausting. The air deflection structure 50 is designed to be movable, and can implement variable air deflection in different states of the electronic device 100, to further avoid or improve blocking impact of the rotating mechanism 30 on air exhausting and impact on the air exhaust direction. This significantly improves heat dissipation effect of the electronic device 100.

FIG. 6 is a diagram of a cross section of the electronic device according to an embodiment of this application.

Refer to FIG. 6. In this embodiment of this application, the electronic device 100 may include the air deflection structure 50. The air deflection structure 50 is disposed on a first housing 10. The air deflection structure 50 may be disposed opposite to the rotating mechanism 30. For example, the air deflection structure 50 may be located on an inner side of the air exhaust vent 41. In other words, the air deflection structure 50 may be located on a side that is of the air exhaust vent 41 and that is opposite to the rotating mechanism 30.

The air deflection structure 50 may block a partial area of the air exhaust vent 41 (for example, a first area 41a of the air exhaust vent 41 in FIG. 6), and an unblocked area of the air exhaust vent 41 can be used to form an air exhaust channel, so that hot air is exhausted from the air exhaust channel. The air deflection structure 50 can act as a guide. The air deflection structure 50 may make the air exhaust channel avoid the rotating mechanism 30, to change the air exhaust position and the air exhaust direction of hot air, so that hot air can avoid blocking of the rotating mechanism 30 or the like and be exhausted out of a chamber 10a. This reduces or avoids an air exhaust resistance generated by blocking, can reduce or avoid a problem of internal heating and temperature rise caused by hot air reflow due to blocking, and significantly improves heat dissipation effect. Therefore, the electronic device has better experience on temperature rise and noise, and the electronic device becomes lighter, thinner, and more portable.

For example, still refer to FIG. 6. For example, the electronic device 100 is in a second intermediate state with a large unfolding angle. The air deflection structure 50 may be located on an inner side of the air exhaust vent 41. The air exhaust vent 41 may be divided into a first area 41a, a second area 41b, and a third area 41c. The first area 41a is located at an end that is of the air exhaust vent 41 and that is adjacent to an upper housing 11, the second area 41b is located at an end that is of the air exhaust vent 41 and that is adjacent to a lower housing 12, and the third area 41c is located between the first area 41a and the second area 41b.

When the electronic device 100 is in the second intermediate state, the rotating mechanism 30 slightly blocks the first area 41a and the second area 41b of the air exhaust vent 41, and has severe blocking impact on air exhausting of the third area 41c, so that the air deflection structure 50 blocks the third area 41c. In this case, the first area 41a and the second area 41b can be separately used to form an air exhaust channel. For example, an airflow channel 40a and the first area 41a form an upper air exhaust channel 43a, and the airflow channel 40a and the second area 41b form a lower air exhaust channel 43b. After being deflected by the air deflection structure 50, hot air may be smoothly exhausted from the upper air exhaust channel 43a and the lower air exhaust channel 43b, so that blocking of the rotating mechanism 30 is avoided, and problems of an air exhaust resistance and hot air reflow caused by blocking are reduced or avoided.

The air deflection structure 50 may have a first deflection slope 50a and a second deflection slope 50b. From the inside of the first housing 10 to the outside of the first housing 10 in a second direction (namely, an x direction), the first deflection slope 50a and the second deflection slope 50b extend obliquely opposite to each other. The first deflection slope 50a and the second deflection slope 50b that extend obliquely can improve deflection performance of the air deflection structure 50, and help change the air exhaust direction, so that after being deflected by the air deflection structure 50, hot air avoids the rotating mechanism 30 and is smoothly exhausted from the air exhaust vent 41.

In this embodiment of this application, the air deflection structure 50 is movably disposed on the first housing 10. In a process in which the rotating mechanism 30 rotates to unfold and fold the first housing 10 and a second housing 20, the air deflection structure 50 may move at the air exhaust vent 41, to adjust the air exhaust channel of the air exhaust vent 41. In other words, a position of the air exhaust channel may be adjusted based on different blocking impact of the rotating mechanism 30 on air exhausting in unfolding and folding processes, to ensure that the air exhaust channel can well avoid the rotating mechanism when the electronic device 100 is in different states. In this way, the electronic device 100 has good heat dissipation effect in different states, and overall heat dissipation effect of the electronic device 100 is improved.

FIG. 7 is a diagram of a cross section of the electronic device in a closed state according to an embodiment of this application.

Refer to FIG. 7. When the electronic device 100 is in the closed state, the rotating mechanism 30 has severe blocking impact on air exhausting in the first area 41a of the air exhaust vent 41. The air deflection structure 50 may be at a first position. For example, the air deflection structure 50 may be disposed adjacent to the upper housing 11. When the air deflection structure 50 is at the first position, the air deflection structure 50 blocks the first area 41a of the air exhaust vent 41, so that the other area (for example, the second area and the third area) of the air exhaust vent 41 is used to form a lower air exhaust channel 43c. Hot air can be smoothly exhausted from the lower air exhaust channel 43c under guidance of the air deflection structure 50. This avoids blocking impact of the rotating mechanism 30 on air exhausting, reduces or avoids an air exhaust resistance caused by blocking, and reduces or avoids a problem like hot air reflow caused by blocking.

FIG. 8 is a diagram of a cross section of the electronic device in an open state according to an embodiment of this application.

Refer to FIG. 8. When the electronic device 100 is in the open state, the rotating mechanism 30 has severe blocking impact on air exhausting in the second area 41b of the air exhaust vent 41. The air deflection structure 50 may move to a second position. For example, the air deflection structure 50 may be disposed adjacent to the lower housing 12. When the air deflection structure 50 is at the second position, the air deflection structure 50 blocks the second area 41b of the air exhaust vent 41, so that the other area (for example, the first area and the third area) of the air exhaust vent 41 may be used to form an upper air exhaust channel 43d. Hot air can be smoothly exhausted from the upper air exhaust channel 43d under guidance of the air deflection structure 50. This avoids blocking impact of the rotating mechanism 30 on air exhausting, and reduces or avoids problems such as an air exhaust resistance and hot air reflow caused by blocking.

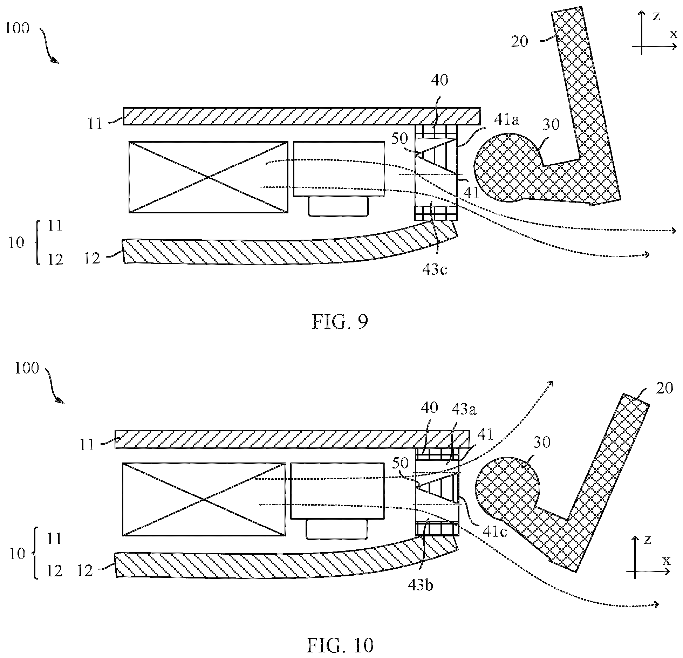

In a process in which the electronic device 100 is unfolded from the closed state to the open state, the air deflection structure 50 may move from the first position to the second position. In other words, when the electronic device 100 is in an intermediate state, the air deflection structure 50 is located between the first position and the second position, the air deflection structure 50 may block at least a part of the third area 41c. It may be understood that, in a process in which the electronic device 100 is in the entire intermediate state, blocking impact of the rotating mechanism 30 on air exhausting in the first area 41a and the second area 41b gradually decreases, and blocking impact of the rotating mechanism 30 on air exhausting in the third area 41c gradually increases (refer to FIG. 10). In this process, the air deflection structure 50 blocks at least a part of the third area 41c. In this case, at least a part of the first area 41a may be used to form an upper air exhaust channel, and at least a part of the second area 41b may be used to form a lower air exhaust channel, so that hot air can be smoothly exhausted from the upper air exhaust channel and the lower air exhaust channel under guidance of the air deflection structure 50. This reduces or avoids problems such as an air exhaust resistance and hot air reflow caused by blocking.

It should be noted that, when the electronic device is in any intermediate state, a position corresponding to the air deflection structure and a blocking degree of the air deflection structure for the third area may be selected and set based on an actual blocking status of the rotating mechanism for the air exhaust vent.

It should be noted that, when the electronic device 100 is switched between different states, the air deflection structure 50 may have a plurality of movement modes (for example, a movement start or stop state).

In addition, the foregoing embodiment is described by using an example in which the air deflection structure 50 blocks the first area when being at the first position, and blocks the second area when being at the second position. Actually, it may be understood that different hinge mechanisms may move in different manners. Therefore, in some possible implementations, the air deflection structure 50 may alternatively block the first area when being at the second position, and block the second area when being at the first position.

It may be understood that, in a process in which the electronic device 100 is folded from the open state to the closed state, the air deflection structure 50 moves reversely, and the air deflection structure 50 may move from the second position to the first position, to ensure that the air deflection structure 50 is at the second position when the electronic device 100 is in the open state, and that the air deflection structure 50 is at the first position when the electronic device 100 is in the closed state. A movement mode of the air deflection structure 50 in the process in which the electronic device 100 is folded from the open state to the closed state may be the same as a movement mode of the air deflection structure 50 in a process in which the electronic device 100 rotates from the closed state to the open state, and movement directions are opposite. In this embodiment of this application, the process in which the electronic device 100 rotates from the closed state to the open state is used as an example for description.

For example, in some examples, the air deflection structure 50 may move when the electronic device 100 continues to be unfolded from the closed state. In other words, the air deflection structure 50 moves in an entire intermediate process in which the electronic device 100 is switched from the closed state to the open state. Finally, when the electronic device 100 is in the open state, the air deflection structure 50 moves to the second position.

Alternatively, in some other examples, the electronic device 100 may be unfolded from the closed state to an intermediate state, for example, to a first intermediate state in which the first housing 10 and the second housing 20 have a small unfolding angle, the air deflection structure 50 may not move.

FIG. 9 is a diagram of a cross section of the electronic device in the first intermediate state according to an embodiment of this application.

For example, as shown in FIG. 9, when the electronic device 100 is in the first intermediate state, the angle between the first housing 10 and the second housing 20 is approximately 75°. In this case, the rotating mechanism 30 still has severe blocking impact on air exhausting in the first area 41a of the air exhaust vent 41. The air deflection structure 50 does not move in a process in which the electronic device 100 is unfolded from the closed state to the first intermediate state, the air deflection structure 50 is at the first position, and hot air is smoothly exhausted from the lower air exhaust channel 43c under guidance of the air deflection structure 50. This avoids blocking by the rotating mechanism 30 or the like.

In a process in which the electronic device 100 continues to be unfolded from the first intermediate state to the open state, the air deflection structure 50 moves, and when the electronic device 100 is in the open state, the air deflection structure 50 moves to the second position. In this way, a movement manner of the air deflection structure 50 can be appropriately controlled based on blocking statuses of the air exhaust vent 41 in different states of the electronic device 100. This helps reduce movement driving energy consumption of the air deflection structure 50 while ensuring that blocking impact on air exhausting can be reduced or avoided, and enriches the movement mode of the air deflection structure 50.

FIG. 10 is a diagram of a cross section of the electronic device in the second intermediate state according to an embodiment of this application.

For example, the electronic device 100 continues to be unfolded from the first intermediate state to the second intermediate state, and the second intermediate state is any intermediate state between the first intermediate state and the open state. Refer to FIG. 10. For example, when the electronic device 100 is in the second intermediate state, the angle between the first housing 10 and the second housing 20 is approximately 110°. In this case, the rotating mechanism 30 has severe blocking impact on air exhausting in the third area 41c, and the air deflection structure 50 may completely block the third area 41c of the air exhaust vent 41. The first area and the second area of the air exhaust vent 41 may be respectively used to form the upper air exhaust channel 43a and the lower air exhaust channel 43b, and hot air can be smoothly exhausted from the upper air exhaust channel 43a and the lower air exhaust channel 43b under guidance of the air deflection structure 50. This avoids blocking by the rotating mechanism 30.

Alternatively, in some other examples, in a process in which the electronic device 100 is unfolded from the closed state to an intermediate state, for example, in a process in which the electronic device 100 is in a third intermediate state in which the first housing 10 and the second housing 20 have a large unfolding angle, the air deflection structure 50 moves from the first position to the second position. For example, when the electronic device 100 is in the third intermediate state, the angle between the first housing 10 and the second housing 20 may be approximately 125°. In this case, the rotating mechanism 30 and the second housing 20 have severe blocking impact on air exhausting in the second area of the air exhaust vent. The air deflection structure 50 is at the second position to block the second area, and hot air can be smoothly exhausted from the upper air exhaust channel under guidance of the air deflection structure 50. This avoids blocking by the rotating mechanism 30.

In a process in which the electronic device 100 is unfolded from the third intermediate state to the open state, if the rotating mechanism 30 still has severe blocking impact on air exhausting in the second area of the air exhaust vent, the air deflection structure 50 may not move. Similarly, under a condition that it is ensured that blocking by the rotating mechanism 30 and the like is reduced or avoided to smoothly exhaust hot air, movement driving energy consumption of the air deflection structure 50 is reduced, and the movement mode of the air deflection structure 50 is further enriched.

It may be understood that, when the electronic device 100 is switched between different states, a specific movement mode of the air deflection structure 50 may be selected and set based on an actual requirement. In this embodiment of this application, an example in which the air deflection structure 50 remains at the first position in the process in which the electronic device 100 is unfolded from the closed state to the first intermediate state (for example, the angle between the first housing 10 and the second housing 20 is approximately 75°), and the air deflection structure 50 moves from the first position to the second position in the process in which the electronic device 100 is unfolded from the first intermediate state to the open state is used for description.

In a possible example, the air deflection structure 50 may be slidably disposed on the first housing 10, and a sliding direction may be a direction in which the upper housing 11 extends to the lower housing 12. For example, the air deflection structure 50 may slide relative to the first housing 10 in a first direction (a direction z). Therefore, the air deflection structure 50 can move between the first position and the second position, to adjust the air exhaust channel.

For example, when the electronic device 100 is in the closed state, and the electronic device 100 is unfolded from the closed state to the first intermediate state with a small unfolding angle, the air deflection structure 50 is always at the first position to block the first area of the air exhaust vent (refer to FIG. 9), and hot air is smoothly exhausted from the lower air exhaust channel 43c.

In the process in which the electronic device 100 is unfolded from the first intermediate state to the open state, the air deflection structure 50 slides in the z direction. For example, the air deflection structure 50 slides from the first position toward the lower housing 12 in the z direction. In this case, the air deflection structure 50 blocks at least a part of the third area 41c (refer to FIG. 10), and hot air can be smoothly exhausted from the upper air exhaust channel 43a and the lower air exhaust channel 43b.

When the electronic device 100 is in the open state, the air deflection structure 50 slides to the second position to block the second area 41b of the air exhaust vent (refer to FIG. 8), and hot air can be smoothly exhausted from the upper air exhaust channel 43d. The air deflection structure 50 slides in the z direction, to adjust the position of the air deflection structure 50, so as to adjust the air exhaust channel. A design of the movement manner is simple, and is easy to implement.

Movement (for example, the foregoing sliding) of the air deflection structure 50 at the air exhaust vent 41 and rotation of the rotating mechanism 30 for implementing unfolding and folding of the electronic device 100 may be implemented independently. For example, the electronic device 100 may include a detection apparatus, and the detection apparatus may be configured to detect a rotation status of the rotating mechanism 30, for example, a rotation angle between the first housing and the second housing. A driving mechanism may be disposed in the electronic device 100. The driving mechanism is configured to drive the air deflection structure 50 to move. A control unit of the electronic device 100 may drive, based on rotation status information detected by the detection apparatus, the air deflection structure 50 to move via the driving mechanism, so that the air deflection structure 50 moves in a rotation process of the rotating mechanism 30 to adjust the air exhaust channel.

Alternatively, linkage may be implemented between movement of the air deflection structure 50 and rotation of the rotating mechanism 30. In other words, in a process in which the rotating mechanism 30 rotates to implement unfolding and folding of the electronic device 100, the air deflection structure 50 is driven to move at the air exhaust vent 41 to adjust the air exhaust channel. The manner of linkage can facilitate control of movement of the air deflection structure 50, and the driving mechanism does not need to be disposed. In this way, energy consumption and costs are reduced.

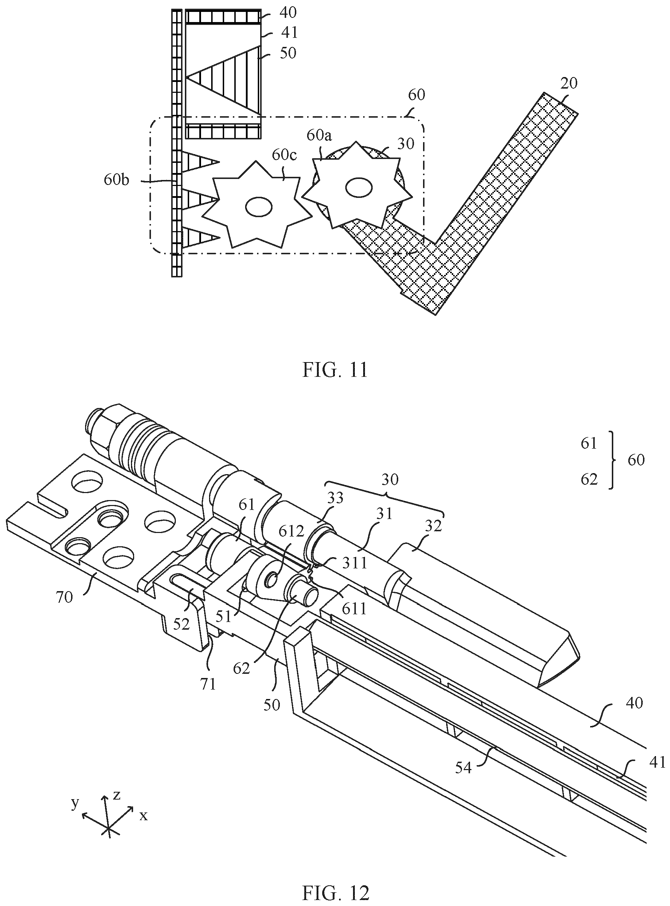

FIG. 11 is a diagram of linkage driving of the air deflection structure in the electronic device according to an embodiment of this application.

For example, the second housing 20 rotatably cooperates with the first housing 10 via the rotating mechanism 30. Refer to FIG. 11. The electronic device 100 may further include a linkage mechanism 60. The linkage mechanism 60 may cooperate with the air deflection structure 50, and the linkage mechanism 60 may further cooperate with the rotating mechanism 30. When the rotating mechanism 30 rotates, the linkage mechanism 60 is driven to move, so that the linkage mechanism 60 drives the air deflection structure 50 to move, and the air deflection structure 50 is at different positions.

The rotating mechanism 30 implements sliding linkage with the air deflection structure 50 in the first direction via the linkage mechanism 60, and there are a plurality of implementations. For example, in an example, still refer to FIG. 11. The linkage mechanism 60 may include a first gear structure 60a and a rack structure 60b, the first gear structure 60a may be fastened to the rotating mechanism 30, and an axis of the first gear structure 60a may be parallel to an axis of the rotating mechanism 30. One end of the rack structure 60b may be fastened to the air deflection structure 50, the rack structure 60b may extend in a direction perpendicular to the axis, the other end of the rack structure 60b may be engaged and cooperate with the first gear structure 60a, and the first gear structure 60a rotates to drive a first rack to slide in the first direction (the z direction). When the rotating mechanism 30 rotates, the rotating mechanism 30 can drive the first gear structure 60a to rotate, and the first gear structure 60a drives the rack structure 60b to move in the first direction, to drive the air deflection structure 50 to move in the first direction.

To expand a movable range of the air deflection structure 50, one or more gear structures may be further disposed between the rack structure 60b and the first gear structure 60a, to increase a transmission ratio, and expand movable ranges of the rack structure 60b and the air deflection structure 50. For example, still refer to FIG. 11. For example, one gear structure is further disposed between the rack structure 60b and the first gear structure 60a. For example, the linkage mechanism 60 may further include a second gear structure 60c, the second gear structure 60c may be located between the first gear structure 60a and the rack structure 60b, and the second gear structure 60c may be engaged and cooperate with both the first gear structure 60a and the rack structure 60b. A rotating shaft 31 rotates to drive the first gear structure 60a to rotate, and the first gear structure 60a drives, via the second gear structure 60c, the rack structure 60b to move in the first direction, to drive the air deflection structure 50 to move in the first direction.

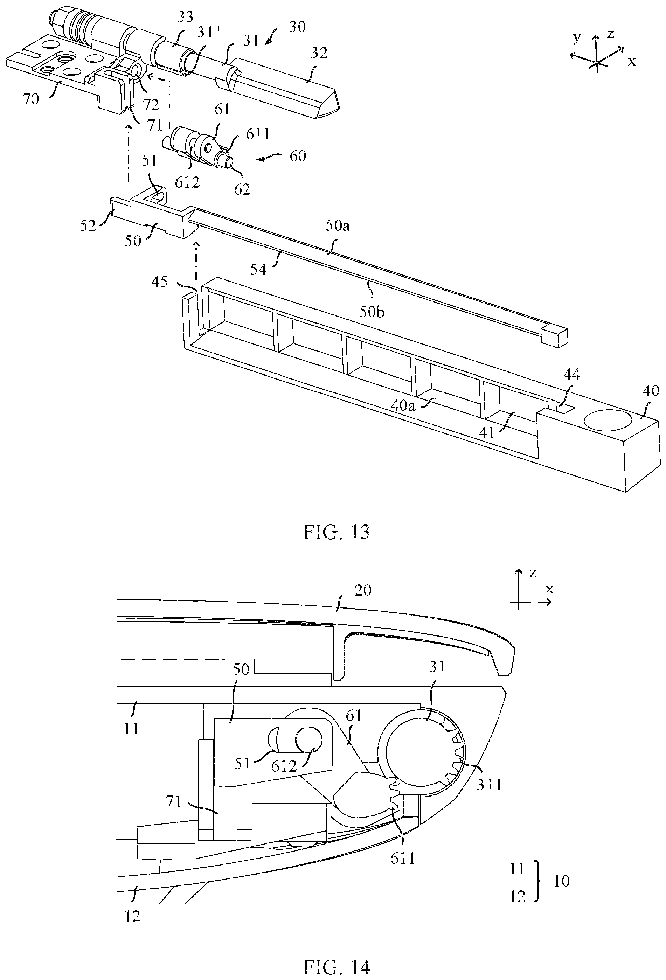

FIG. 12 is a diagram of assembly of the rotating mechanism, the linkage mechanism, and the air deflection structure in the electronic device according to an embodiment of this application. FIG. 13 is a diagram of splitting of the rotating mechanism, the linkage mechanism, and the air deflection structure in the electronic device according to an embodiment of this application.

Alternatively, in another example, as shown in FIG. 12, the rotating mechanism 30 may include the rotating shaft 31. The rotating shaft 31 may be fastened to the second housing, a shaft hole (not shown in the figure) used to cooperate with the rotating shaft 31 may be opened on the first housing, and the rotating shaft 31 may be inserted into the shaft hole and rotate relative to the shaft hole, so that the second housing can rotate relative to the first housing via the rotating shaft 31, to fold and unfold the electronic device.

For example, the rotating mechanism 30 may further include a bearing member 32. The rotating shaft 31 may be fastened to the bearing member 32, and the bearing member 32 is fastened to the second housing, to implement fastening between the rotating shaft 31 and the second housing.

With reference to FIG. 13, the electronic device 100 may further include a first assembly frame 70. The first assembly frame 70 may be fastened to the first housing, and a shaft hole may be opened on the first assembly frame 70, so that the rotating shaft 31 can rotatably cooperate with the first assembly frame 70.

Alternatively, the air deflection structure 50 may be slidably disposed on the first assembly frame 70, and can slide relative to the first assembly frame 70 in the z direction, so that the air deflection structure 50 can be slidably disposed relative to the first housing in the z direction.

The linkage mechanism 60 may include a first connecting rod 61. A first end of the first connecting rod 61 is rotatably disposed on the first housing, and the first connecting rod 61 may rotate around a direction parallel to the axis of the rotating mechanism (namely, a y direction). For example, the first connecting rod 61 may be rotatably disposed on the first assembly frame 70, so that the first connecting rod 61 rotatably cooperates with the first housing.

For example, the linkage mechanism 60 may further include a rotating member 62. The first end of the first connecting rod 61 may be fastened to the rotating member 62. The first assembly frame 70 may have an assembly hole 72 (as shown in FIG. 13), and the rotating member 62 may be inserted into the assembly hole 72, and rotatably cooperate with the assembly hole 72, so that the first connecting rod 61 rotatably cooperates with the first assembly frame 70.

In actual assembly, the first connecting rod 61, the rotating shaft 31, the air deflection structure 50, and the like may be first fastened to the first assembly frame 70, and then assembled to the first housing 10 as a whole via the first assembly frame 70. This facilitates assembly of the air deflection structure 50 and the like, and helps improve assembly efficiency.

The first end of the first connecting rod 61 is configured to cooperate with the rotating shaft 31, and the second end of the first connecting rod 61 is configured to cooperate with the air deflection structure 50. When the first housing 10 and the second housing 20 rotate relative to each other, the rotating shaft 31 rotates to drive the first end of the first connecting rod 61 to rotate relative to the first housing 10 (the first assembly frame 70). The second end of the first connecting rod 61 can drive the air deflection structure 50 to slide in the z direction, so that the air deflection structure 50 can move from the first position to the second position, to block different areas of the air exhaust vent, so as to adjust the air exhaust channel. The first connecting rod 61 rotates to drive the air deflection structure 50 to move in the z direction, so that a transmission ratio can be increased. This helps increase a movable stroke of the air deflection structure 50, expand a position adjustment range of the air deflection structure 50, and enrich an applicable scenario of the air deflection structure 50.

Specifically, with reference to FIG. 12 and FIG. 13, at least a part of a periphery of the rotating shaft 31 may have a first tooth structure 311. For example, the rotating mechanism 30 may further include a first gear 33, the first gear 33 is sleeved on the rotating shaft 31, and a periphery of the first gear 33 has a first tooth structure 311.

The first end of the first connecting rod 61 may have a second tooth structure 611, and the first tooth structure 311 is engaged and cooperates with the second tooth structure 611, so that when the rotating shaft 31 rotates, the first end of the first connecting rod 61 can be driven to rotate.

Through cooperation between the first tooth structure 311 and the second tooth structure 611, linkage between the rotating shaft 31 and both the first connecting rod 61 and the air deflection structure 50 can be implemented, and the air deflection structure 50 can be reset. This meets a position movement requirement of the air deflection structure 50 in a case in which the electronic device 100 is switched between the closed state and the open state. For example, in the process in which the electronic device 100 is unfolded from the closed state to the open state, the rotating shaft 31 rotates clockwise, to drive the first end of the first connecting rod 61 to rotate, so as to drive the air deflection structure 50 to move from the first position to the second position in the z direction. In the process in which the electronic device 100 is folded from the open state to the closed state, the rotating shaft 31 rotates counterclockwise, to drive, via the first connecting rod 61, the air deflection structure 50 to move reversely from the second position to the first position. This meets air deflection requirements of the electronic device 100 in different states.

The first tooth structure 311 may be disposed around the part of the periphery of the rotating shaft 31. In other words, the first tooth structure 311 is distributed on a part of the periphery of the first gear 33. In a process in which the rotating shaft 31 rotates for one circle, the first tooth structure 311 is engaged with the second tooth structure 611 in only a part of a rotation track, to drive the air deflection structure 50 to move. However, the first tooth structure 311 is not engaged with the second tooth structure 611 in a part of the rotation track, and the air deflection structure 50 does not move. For example, in the process in which the electronic device rotates from the closed state to the first intermediate state, the first tooth structure 311 of the rotating shaft is not engaged with the second tooth structure 611 on the first connecting rod 61, and the air deflection structure 50 may always remain at the first position. The first tooth structure 311 is engaged with the second tooth structure 611 in only the process in which the electronic device rotates from the first intermediate state to the open state. The air deflection structure 50 moves in a rotation process of the rotating shaft 31, to move from the first position to the second position. This meets a requirement that the air deflection structure does not move in the process in which the electronic device rotates from the closed state to the first intermediate state.

The rotating shaft 31 rotates to drive, via the first tooth structure 311 and the second tooth structure 611, the first end of the first connecting rod 61 to rotate, the second end of the first connecting rod 61 may slidably cooperate with the air deflection structure 50, and the second end of the first connecting rod 61 can slide relative to the air deflection structure 50 in the second direction (namely, the x direction). Refer to FIG. 12. The first end of the first connecting rod 61 rotates to drive the second end of the first connecting rod 61 to move along an arc-shaped track, so that the second end of the first connecting rod 61 slides relative to the air deflection structure 50 in the x direction, and a movement component of the arc-shaped movement track of the second end of the first connecting rod 61 in the x direction is released. A movement component of the arc-shaped movement track of the second end of the first connecting rod 61 in the y direction acts on the air deflection structure 50, to drive the air deflection structure 50 to slide relative to the first housing (the first assembly frame 70) in the y direction (namely, the first direction), so that the air deflection structure 50 slides in the first direction, and the air deflection structure 50 can slide between the first position and the second position.

To implement sliding cooperation between the second end of the first connecting rod 61 and the air deflection structure 50, one of the air deflection structure and the second end of the first connecting rod may have a first guide rail, and the other one of the air deflection structure and the second end of the first connecting rod may have a first sliding member. For example, refer to FIG. 13. The air deflection structure 50 may be provided with the first guide rail 51, and the first connecting rod 61 may have the first sliding member 612. An extension direction of the first guide rail 51 is the second direction (the x direction). As shown in FIG. 12, the first sliding member 612 is slidably disposed along the first guide rail 51, so that the first connecting rod 61 and the air deflection structure 50 can slide relative to each other in the x direction.

The first guide rail 51 and the first sliding member 612 may have a plurality of structural implementation forms. For example, as shown in FIG. 13, the first guide rail 51 may be a through groove formed on the air deflection structure 50, the first sliding member 612 may be a pin shaft disposed on the second end of the first connecting rod 61, and the pin shaft may penetrate the through groove and slide along the through groove.

Certainly, in some other examples, the first guide rail 51 and the first sliding member 612 may alternatively be any other structures that can slide relative to each other. For example, the first guide rail 51 may be a protruding rail member, the first sliding member 612 may be a groove formed at the second end of the first connecting rod 61, and the groove may slide along the guide rail member. Alternatively, the first guide rail 51 may be a sliding groove, the first sliding member 612 may be a sliding block formed through protruding on the second end of the first connecting rod 61, and the sliding block can extend into the sliding groove and slide along the sliding groove, or the like.

To implement sliding cooperation between the air deflection structure and the first housing, a second guide rail may be formed on one of the air deflection structure and the first housing, and a second sliding member may be formed on the other one of the air deflection structure and the first housing. For example, still refer to FIG. 13. The second sliding member 52 may be formed on the air deflection structure 50, and the second guide rail 71 may be formed on the first assembly frame 70 of the first housing 10, so that an extension direction of the second guide rail 71 may be the second direction (the z direction). As shown in FIG. 12, the second sliding member 52 is slidably disposed along the second guide rail 71, so that the air deflection structure 50 and the first assembly frame 70 (the first housing) can slide relative to each other in the z direction.

Correspondingly, the second guide rail 71 and the second sliding member 52 may also have a plurality of structural implementation forms. For example, as shown in FIG. 13, the second guide rail 71 may be a sliding groove formed on the first assembly frame 70, the second sliding member 52 may be a sliding block formed by protruding on the air deflection structure 50, and the sliding block may extend into the sliding slot and slide along the sliding slot.

Certainly, in some other examples, the second guide rail 71 and the second sliding member 52 may alternatively be any other structures that can slide relative to each other. For example, the second guide rail 71 may be a rail member formed by protruding on the first assembly frame 70, the second sliding member 52 may be a groove formed on a side wall of the air deflection structure 50, and the groove may slide along the guide rail member, or the like.

When the first housing 10 and the second housing 20 rotate relative to each other, the rotating shaft 31 rotates. With reference to FIG. 12, the first tooth structure 311 of the rotating shaft 31 is engaged with the second tooth structure 611, to drive the first end of the first connecting rod 61 to rotate. The second end of the first connecting rod 61 slides relative to the first guide rail 51, and the second end of the first connecting rod 61 may drive the second sliding member 52 of the air deflection structure 50 to slide relative to the second guide rail 71. The air deflection structure 50 slides relative to the first assembly frame 70 (the first housing) in the z direction, so that the air deflection structure 50 slides between the first position and the second position.

In this example, only one end of the air deflection structure 50 may be cooperatively connected to the linkage mechanism 60, and the other end of the air deflection structure 50 may be movably disposed with the first housing, the air exhaust structure 40, or the like. This can reduce disposing of the linkage mechanism 60 while ensuring movement stability of the air deflection structure 50. In this way, a structure is simplified, and costs are reduced.

For example, as shown in FIG. 13, the air deflection structure 50 may be disposed across the air exhaust structure 40. The air deflection structure 50 includes a first end and a second end that are opposite to each other in the y direction. The first end of the air deflection structure 50 may movably cooperate with a first end of the air exhaust structure 40, to ensure movement stability of the two ends of the air deflection structure 50. The second end of the air deflection structure 50 may extend out of a second end of the air exhaust structure 40, so that the second end of the air deflection structure 50 is connected to the linkage mechanism 60. The air deflection structure 50 is disposed on the air exhaust structure 40, and no additional assembly fastener needs to be disposed. This helps simplify an overall structure and reduce costs.

The second end of the air exhaust structure 40 may have a first avoidance groove 45, and an extension direction of the first avoidance groove 45 may be parallel to an extension direction of the second guide rail 71. In other words, the first avoidance groove 45 may extend in the z direction, and the second end of the air deflection structure 50 extends out of the air exhaust structure 40 through the first avoidance groove 45, to avoid the air deflection structure 50 and ensure that the air deflection structure 50 can translate in the z direction.

An alignment slot 44 may be opened on the first end of the air exhaust structure 40, the first end of the air deflection structure 50 may slidably cooperate with the alignment slot 44, and an extension direction of the alignment slot 44 may also be the same as the extension direction of the second guide rail 71, to ensure that the air deflection structure 50 can translate in the z direction.

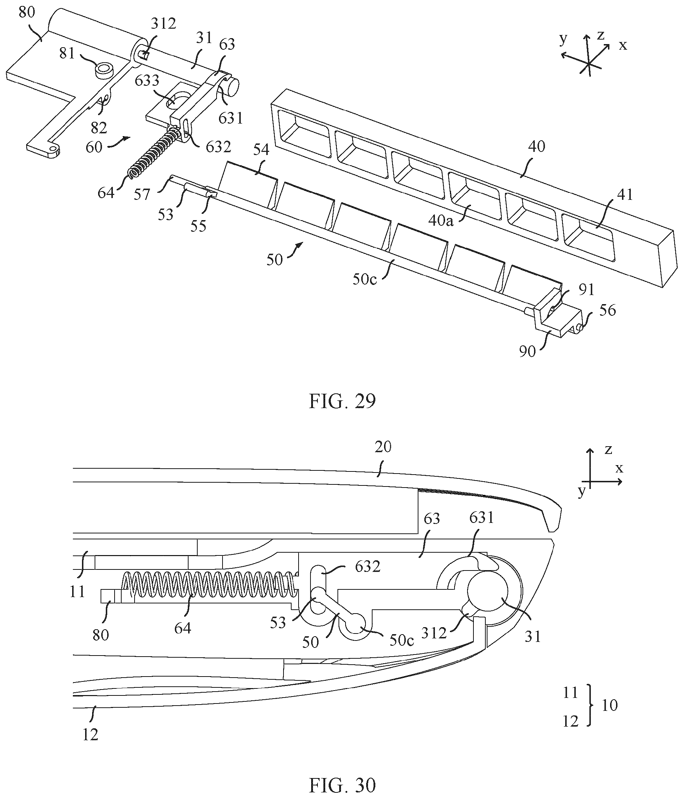

Certainly, in some other examples, an assembly fastener, for example, a fastening bracket 90 (refer to FIG. 29), may be fastened to the first housing 10, so that the first end of the air deflection structure 50 movably cooperates with the fastening bracket, and the second end of the air deflection structure 50 cooperates with the linkage mechanism 60. This meets stability of translation of the air deflection structure 50.

Still refer to FIG. 13. An airflow channel 40a is formed on the air exhaust structure 40. With reference to FIG. 12, the air deflection structure 50 may be located on a side that is of the airflow channel 40a and that is opposite to the rotating mechanism. In other words, the air deflection structure 50 and the airflow channel 40a are disposed in parallel in the x direction, and hot air deflected by the air deflection structure 50 is exhausted from the air exhaust vent 41 through the airflow channel 40a.

Certainly, in some other examples, the air deflection structure 50 may alternatively partially extend into the airflow channel 40a, to block the air exhaust vent 41. This helps reduce overall space occupied by the air deflection structure 50 and the air exhaust structure 40, and improve a structural layout inside the first housing 10. In addition, an assembly design manner of the air deflection structure 50 is enriched, to meet a requirement in a wider structural scenario.

In addition, an air deflection unit 54 may be disposed on the air deflection structure 50. The air deflection unit 54 may be opposite to the air exhaust vent 41. A first deflection slope and a second deflection slope are formed on the air deflection unit 54, to adjust the air exhaust position and the air exhaust direction. In the second direction, from an end that is of the air deflection unit 54 and that is opposite to the rotating mechanism to an end that is of the air deflection unit 54 and that faces the rotating mechanism, the first deflection slope and the second deflection slope obliquely extend opposite to each other.

Refer to FIG. 12 and FIG. 13. The air deflection unit 54 may be an entire mechanical part. For example, the air deflection unit 54 may be a triangular mechanical part extending in the third direction (the y direction), a cross section of the air deflection unit 54 (a cross section along an x-z plane) is a triangle, and the entire air deflection unit 54 may extend into the airflow channel 40a.

Certainly, in some other examples, there may be a plurality of air deflection units 54 (as shown in FIG. 29), and the plurality of air deflection units may be spaced from each other in the y direction. The airflow channel 40a may be divided into a plurality of compartments, the air deflection units may extend into the airflow channel 40a, and each air deflection unit is correspondingly located in one compartment. This helps improve deflection performance of the air deflection structure 50, and enriches a structural design of the air deflection structure 50, to extend an applicable range of the air deflection structure 50.

A cross-sectional shape of each air deflection unit may also be a triangle. Alternatively, in some other examples, the cross-sectional shape of the air deflection unit may be another regular or irregular shape. For example, the cross-sectional shape of the air deflection unit may be a trapezoid or a polygon.

The following describes the position and a translation manner of the air deflection structure with reference to an example of a specific state of the electronic device.

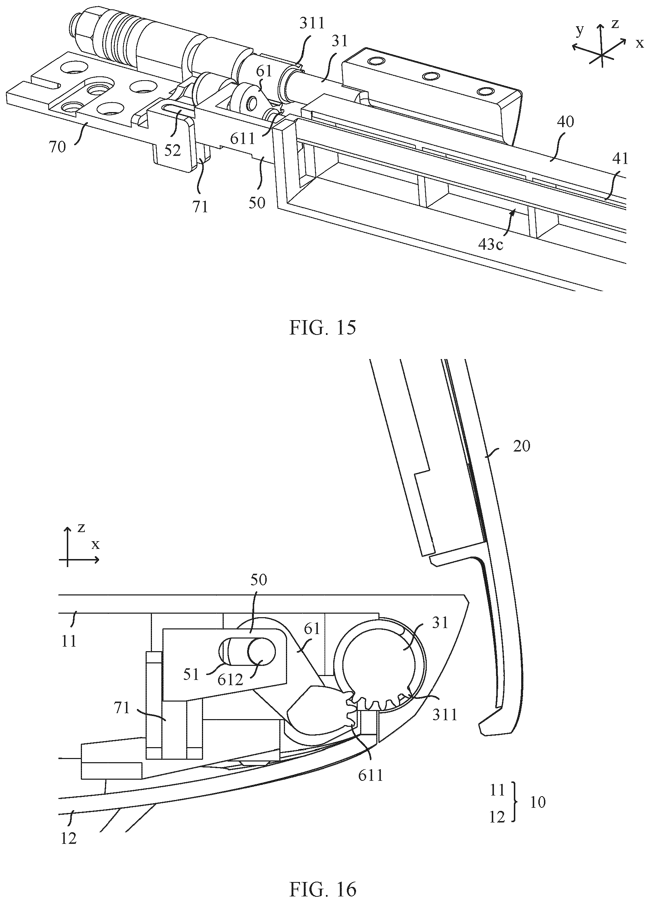

FIG. 14 is a diagram of a cross-sectional structure of the electronic device in the closed state according to an embodiment of this application. FIG. 15 is a diagram of assembly of the air deflection structure, the linkage mechanism, and the air exhaust structure in a case in which the electronic device is in the closed state according to an embodiment of this application.

When the electronic device 100 is in the closed state, as shown in FIG. 14, for example, the angle between the first housing 10 and the second housing 20 is approximately 0°, and the first tooth structure 311 of the rotating shaft 31 is not engaged with the second tooth structure 611 of the first connecting rod 61. In this case, the air deflection structure 50 is at the first position. For example, the second sliding member of the air deflection structure 50 may be located at the top that is of the second guide rail 71 and that is adjacent to the upper housing 11. With reference to FIG. 15, when the air deflection structure 50 is at the first position, the air deflection structure 50 blocks the first area of the air exhaust vent 41, and hot air may be smoothly exhausted from the lower air exhaust channel 43c.

In a process in which the electronic device 100 is unfolded from the closed state to an intermediate state with a small angle, the rotating shaft 31 continues to rotate, and the first tooth structure 311 is still not engaged with the second tooth structure 611, so that the air deflection structure 50 remains at the first position.

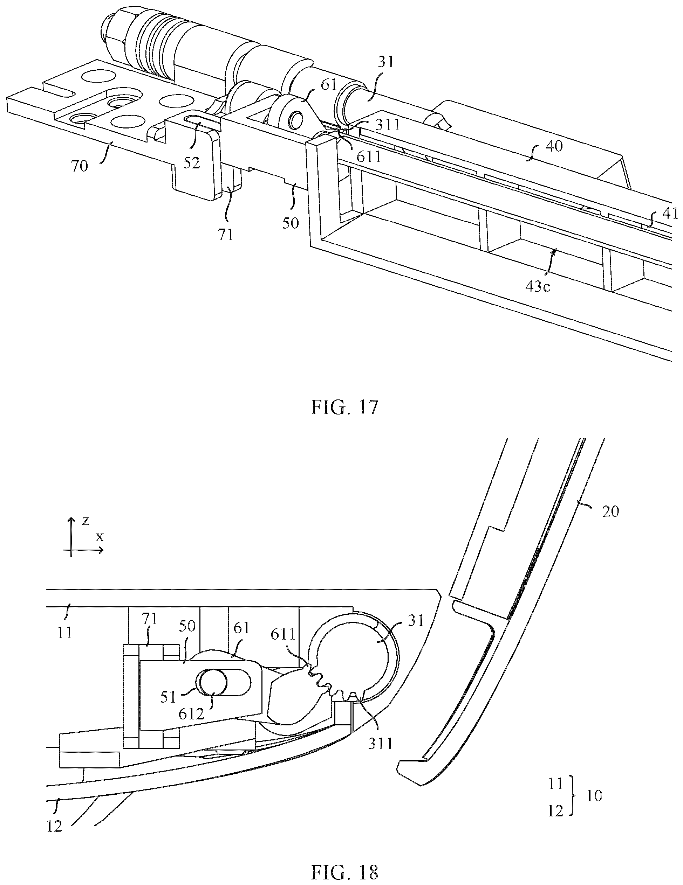

FIG. 16 is a diagram of a cross-sectional structure of the electronic device in the first intermediate state according to an embodiment of this application. FIG. 17 is a diagram of assembly of the air deflection structure, the linkage mechanism, and the air exhaust structure in a case in which the electronic device is in the first intermediate state according to an embodiment of this application.

When the electronic device 100 is in the first intermediate state, as shown in FIG. 16, for example, the angle between the first housing 10 and the second housing 20 is approximately 75°, the air deflection structure 50 is still at the first position, and the first tooth structure 311 may be in contact but still not engaged and cooperate with the second tooth structure 611. With reference to FIG. 17, the air deflection structure 50 blocks the first area of the air exhaust vent 41, and hot air is smoothly exhausted from the lower air exhaust channel 43c.

When the electronic device 100 continues to be unfolded from the first intermediate state, the rotating shaft 31 continues to rotate relative to the first connecting rod 61. In this case, the first tooth structure 311 is engaged and cooperates with the second tooth structure 611, the first end of the first connecting rod 61 rotates, and the second end of the first connecting rod 61 slides relative to the first guide rail 51, so that the air deflection structure 50 slides downward toward the lower housing along the second guide rail 71, and the air deflection structure 50 translates from the first position to the second position.

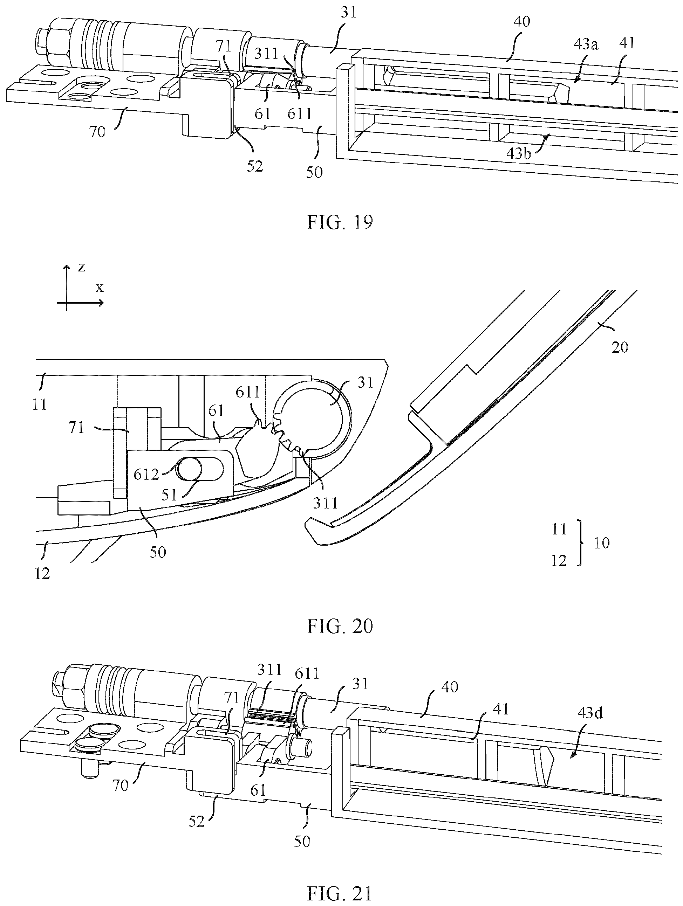

FIG. 18 is a diagram of a cross-sectional structure of the electronic device in the second intermediate state according to an embodiment of this application. FIG. 19 is a diagram of assembly of the air deflection structure, the linkage mechanism, and the air exhaust structure in a case in which the electronic device is in the second intermediate state according to an embodiment of this application.

For example, when the electronic device 100 is unfolded from the first intermediate state to the second intermediate state, as shown in FIG. 18, for example, when the electronic device 100 is in the second intermediate state, the angle between the first housing 10 and the second housing 20 is approximately 110°. The first tooth structure 311 is engaged and cooperates with the second tooth structure 611, and the air deflection structure 50 is located between the first position and the second position, for example, the second sliding member of the air deflection structure 50 moves to a middle position of the second guide rail 71. With reference to FIG. 19, the air deflection structure 50 blocks the third area of the air exhaust vent 41, and hot air can be smoothly exhausted from both the upper air exhaust channel 43a and the lower air exhaust channel 43b.

In a process in which the electronic device 100 is unfolded from the second intermediate state to the open state, the rotating shaft 31 rotates to continue to drive the air deflection structure 50 to move downward along the second guide rail 71, so that the air deflection structure 50 finally moves to the second position.

FIG. 20 is a diagram of a cross-sectional structure of the electronic device in the open state according to an embodiment of this application. FIG. 21 is a diagram of assembly of the air deflection structure, the linkage mechanism, and the air exhaust structure in a case in which the electronic device is in the open state according to an embodiment of this application.

When the electronic device 100 is in the open state, as shown in FIG. 20, when the angle between the first housing 10 and the second housing 20 is approximately 135°, the air deflection structure 50 is at the second position, for example, the second sliding member of the air deflection structure 50 may be at the bottom end that is of the second guide rail 71 and that is adjacent to the lower housing 12. With reference to FIG. 21, the air deflection structure 50 blocks the second area of the air exhaust vent 41, and hot air can be smoothly exhausted from the upper air exhaust channel 43d.

In another possible example, the air deflection structure 50 may alternatively be rotatably disposed on the first housing 10, so that the air deflection structure 50 can rotate in an arc shape around the third direction (namely, the y direction) relative to the first housing 10. In this way, the air deflection structure 50 moves between the first position and the second position, to adjust the air exhaust channel.

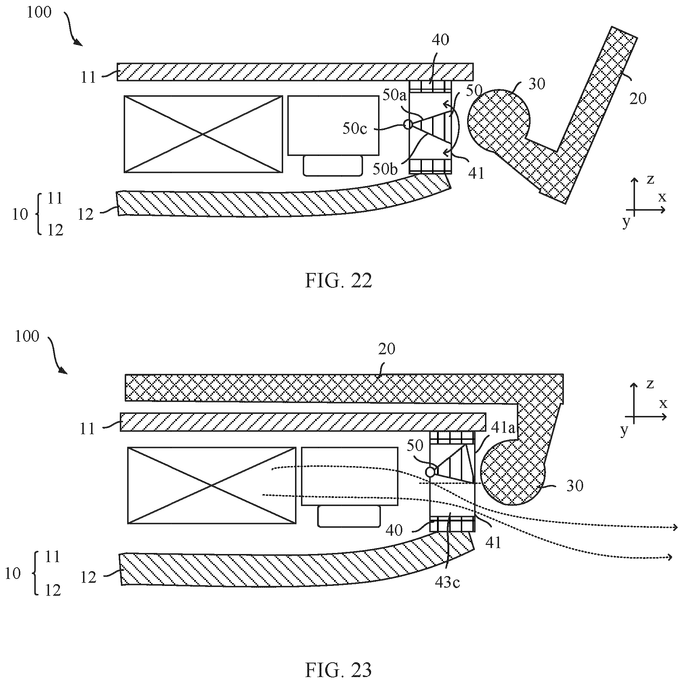

FIG. 22 is a diagram of another cross section of the electronic device according to an embodiment of this application.

Refer to FIG. 22. An end part of an end of the air deflection structure 50 forms a rotating end 50c, and the first deflection slope 50a and the second deflection slope 50b may be located on two sides of the rotating end 50c. For example, a cross-sectional shape of the air deflection structure 50 may be a triangle. In this case, a vertex end of the triangle may form the rotating end 50c, and planes on which two sides connected to the vertex end are located may form the first deflection slope 50a and the second deflection slope 50b.

The rotating end 50c is rotatably disposed on the first housing 10, so that the air deflection structure 50 is rotatably disposed on the first housing 10 via the rotating end 50c, and the air deflection structure 50 can rotate around the y direction. In other words, the rotating end 50c does not have displacement in the x, y, and z directions, and the entire air deflection structure 50 rotates around an axis of the rotating end 50c. For example, an end that is of the air deflection structure 50 and that is opposite to the rotating end 50c is a moving end. The moving end generates, on an x-z plane, an arc-shaped movement track with the rotating end 50c as a circle center, to change the position of the air deflection structure 50, so that the air deflection structure 50 can move from the first position to the second position, to block different areas of the air exhaust vent 41, so as to adjust the air exhaust channel. This enriches a movement implementation of the air deflection structure 50, and helps extend the applicable scenario of the air deflection structure 50.

FIG. 23 is a diagram of another cross section of the electronic device in the closed state according to an embodiment of this application.

Refer to FIG. 23. When the electronic device 100 is in the closed state, the air deflection structure 50 is at the first position, the air deflection structure 50 blocks the first area 41a of the air exhaust vent 41, and hot air can be smoothly exhausted from the lower air exhaust channel 23c.

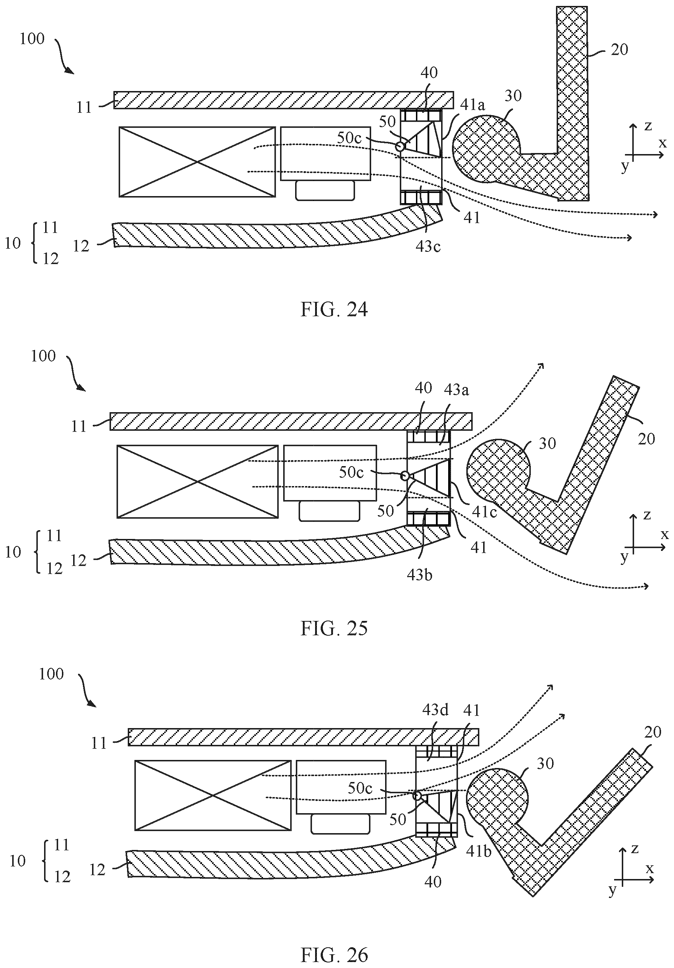

FIG. 24 is a diagram of another cross section of the electronic device in the first intermediate state according to an embodiment of this application.

When the electronic device 100 is in an intermediate state with a small unfolding angle, for example, when the electronic device 100 is in the first intermediate state, the angle between the first housing 10 and the second housing 20 is approximately 90°, the rotating mechanism 30 still has severe blocking impact on air exhausting in the first area 41a of the air exhaust vent 41, the air deflection structure 50 is still at the first position, and hot air is smoothly exhausted from the lower air exhaust channel 43c.

In the process in which the electronic device 100 is unfolded from the first intermediate state to the open state, the rotating end 50c of the air deflection structure 50 rotates, so that the entire air deflection structure 50 rotates around the axis of the rotating end 50c (that is, around the y direction), the air deflection structure 50 moves from the first position along an arc-shaped movement track toward the lower housing 12, and the air deflection structure 50 blocks at least a part of the third area 41c.

FIG. 25 is a diagram of another cross section of the electronic device in the second intermediate state according to an embodiment of this application.

For example, when the electronic device 100 is in the second intermediate state, the angle between the first housing 10 and the second housing 20 is approximately 110°, the air deflection structure 50 blocks the third area 41c of the air exhaust vent 41, and hot air can be smoothly exhausted from the upper air exhaust channel 43a and the lower air exhaust channel 43b.

FIG. 26 is a diagram of another cross section of the electronic device in the open state according to an embodiment of this application.

Refer to FIG. 26. When the electronic device 100 is in the open state, the air deflection structure 50 rotates to the second position, the air deflection structure 50 blocks the second area 41b of the air exhaust vent 41, and hot air can be smoothly exhausted from the upper air exhaust channel 43d.

Correspondingly, in this example, rotation of the air deflection structure 50 and rotation of the rotating mechanism 30 may be independently implemented, or linkage may be implemented between rotation of the air deflection structure 50 and rotation of the rotating mechanism.

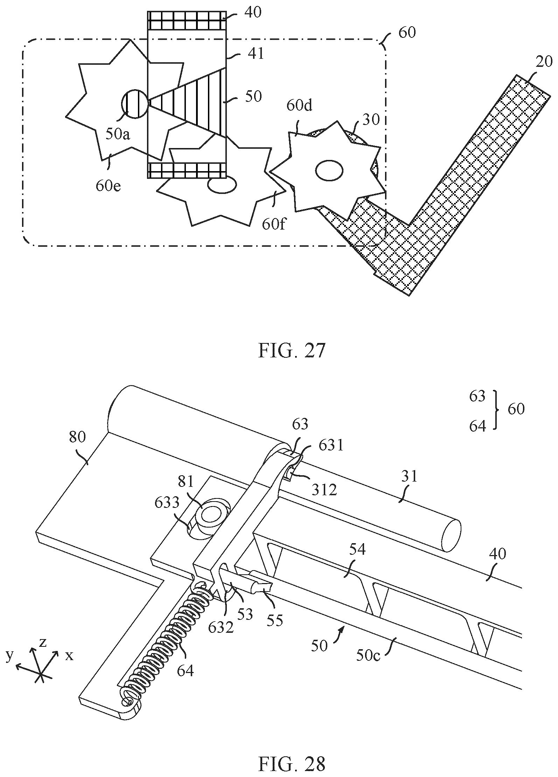

FIG. 27 is another diagram of linkage driving of the air deflection structure in the electronic device according to an embodiment of this application.

For example, as shown in FIG. 27, linkage may alternatively be implemented between the air deflection structure 50 and the rotating mechanism 30 via the linkage mechanism 60. The linkage mechanism 60 may be connected to the rotating end 50c of the air deflection structure 50, and the linkage mechanism 60 may further cooperate with the rotating mechanism 30. When the rotating mechanism 30 rotates, the rotating mechanism 30 drives the linkage mechanism 60 to move, and the linkage mechanism 60 drives the air deflection structure 50 to rotate, so that the air deflection structure 50 is at different positions.

The rotating mechanism 30 implements rotational linkage with the air deflection structure 50 via the linkage mechanism 60, and there may alternatively be a plurality of implementations. For example, in an example, still refer to FIG. 27. The linkage mechanism 60 may include at least two gear structures. For example, the linkage mechanism may include a third gear structure 60d and a fourth gear structure 60e, the third gear structure 60d may be fastened to the rotating mechanism 30, and the fourth gear structure 60e may be fastened to the rotating end 50c of the air deflection structure 50. An axis of the third gear structure 60d and an axis of the fourth gear structure 60e may be separately parallel to the axis of the rotating mechanism 30, and the third gear structure 60d may be engaged and cooperate with the fourth gear structure 60e. When relative rotation of the housings drives the rotating shaft 31 to rotate, the rotating shaft 31 can drive the third gear structure 60d to rotate, and the third gear structure 60d drives the fourth gear structure 60e to rotate, to drive the rotating end 50c rotate around the direction parallel to the axis of the rotating mechanism 30.

The linkage mechanism 60 may include more than two gear structures. For example, one or more gear structures may be further disposed between the third gear structure 60d and the fourth gear structure 60e, to increase a transmission ratio. This helps expand a rotatable range of the air deflection structure 50. For example, still refer to FIG. 27. For example, one gear structure is further disposed between the third gear structure 60d and the fourth gear structure 60e. For example, the linkage mechanism may further include a fifth gear structure 60f, and the fifth gear structure 60f may be located between the third gear structure 60d and the fourth gear structure 60e. The fifth gear structure 60f is engaged and cooperates with both the third gear structure 60d and the fourth gear structure 60e, the rotating shaft 31 rotates to drive the third gear structure 60d to rotate, and the third gear structure 60d drives, via the fifth gear structure 60f, the fourth gear structure 60e to rotate, to drive the rotating end 50c of the air deflection structure 50 to rotate.

FIG. 28 is another diagram of assembly of the rotating shaft, the linkage mechanism, and the air deflection structure in the electronic device according to an embodiment of this application. FIG. 29 is another diagram of splitting of the rotating shaft, the linkage mechanism, and the air deflection structure in the electronic device according to an embodiment of this application.

Alternatively, in another example, as shown in FIG. 28, the rotating mechanism includes the rotating shaft 31, the second housing may be fastened to the rotating shaft 31, and the rotating shaft 31 may rotatably cooperate with the first housing.

The electronic device 100 may include a second assembly frame 80. The second assembly frame 80 may be fastened to the first housing 10, a shaft hole (not shown in the figure) is opened on the second assembly frame 80, and the rotating shaft 31 may rotatably cooperate with the second assembly frame 80.

The linkage mechanism 60 may include a second connecting rod 63. The second connecting rod 63 may be movably disposed in the first housing 10, and the second connecting rod 63 can slide in the second direction (the x direction). For example, the second connecting rod 63 may be movably disposed on the second assembly frame 80, to implement sliding disposition between the second connecting rod 63 and the first housing 10.

A first end of the second connecting rod 63 is configured to cooperate with the rotating shaft 31, and a second end of the second connecting rod 63 cooperates with the rotating end 50c of the air deflection structure 50. When the rotating shaft 31 rotates, the rotating shaft 31 can drive the second connecting rod 63 to move in the x direction, and the second connecting rod 63 can drive the rotating end 50c of the air deflection structure 50 to rotate around the y direction, so that the air deflection structure 50 can move between the first position and the second position, to block different areas of the air exhaust vent, so as to adjust the air exhaust channel. In this way, a structure design is simpler and is easy to implement.

Specifically, with reference to FIG. 28 and FIG. 29, a first limiting structure 312 may be formed on an outer wall of the rotating shaft 31, a second limiting structure 631 may be formed on the second connecting rod 63, and the first limiting structure 312 is configured to abut against and cooperate with the second limiting structure 631, so that when rotating, the rotating shaft 31 can drive the second connecting rod 63 to slide in the x direction, and the second connecting rod 63 drives the air deflection structure 50 to rotate.

For example, the first limiting structure 312 may be a protrusion member formed by protrusion on a side wall of the periphery of the rotating shaft 31, the second limiting member may be an arc-shaped groove formed on a side wall of the second connecting rod 63, and the protrusion member can extend into the arc-shaped groove and slide along the arc-shaped groove.

It may be understood that, in a process in which the protrusion member slides in the arc-shaped groove, the protrusion member does not abut against and cooperate with the arc-shaped groove, and rotation of the rotating shaft does not drive the air deflection structure 50 to rotate. When the protrusion member abuts against and cooperates with the bottom end of the arc-shaped groove, the rotating shaft 31 can rotate to drive, via the second connecting rod 63, the air deflection structure 50 to rotate. For example, in the process in which the electronic device rotates from the closed state to the first intermediate state, the protrusion member (the first limiting structure 312) of the rotating shaft 31 slides in the arc-shaped groove (the second limiting structure 631) of the second connecting rod 63, the protrusion member does not abut against and cooperate with the arc-shaped groove, and the air deflection structure 50 may always remain at the first position. In the process in which the electronic device rotates from the first intermediate state to the open state, the protrusion member (the first limiting structure 312) abuts against and cooperates with the bottom end of the arc-shaped groove (the second limiting structure 631), and the air deflection structure 50 rotates around the rotating end in a rotation process of the rotating shaft 31, to move from the first position to the second position. This can also meet the requirement that the air deflection structure does not move in the process in which the electronic device rotates from the closed state to the first intermediate state.

In addition, in the process in which the electronic device rotates from the closed state to the open state, the first limiting structure 312 abuts against and cooperates with the second limiting structure 631, so that the rotating shaft 31 rotates to drive the second connecting rod 63 to move in the x direction (for example, move toward the second housing), to drive the air deflection structure 50 to rotate around the rotating end of the air deflection structure 50. In this way, the air deflection structure 50 moves from the first position to the second position. When the electronic device rotates reversely, that is, in the process in which the electronic device rotates from the open state to the closed state, the first limiting structure 312 may not abut against and cooperate with the second limiting structure 631. Refer to FIG. 28. To reset the second connecting rod 63 to adjust the position of the air deflection structure 50 when the electronic device is unfolded again, the linkage mechanism 60 may further include an elastic member 64.

One end of the elastic member 64 is connected to the first housing 10, for example, one end of the elastic member 64 may be fastened to the second assembly frame 80, and the other end of the elastic member 64 is fastened to the second connecting rod 63. The second connecting rod 63 may repeatedly move (toward the second housing or away from the second housing) through elastic recovery performance of the elastic member 64, to reset the air deflection structure 50. This meets a position movement requirement of the air deflection structure 50 in a case in which the electronic device is switched between the closed state and the open state.

For example, in the process in which the electronic device is unfolded from the closed state to the open state, the rotating shaft 31 rotates clockwise to drive the second connecting rod 63 to move toward the second housing (in the x direction). In this case, the elastic member 64 may be in a stretched state, and the second connecting rod 63 drives the air deflection structure 50 to move from the first position to the second position. However, in the process in which the electronic device is folded from the open state to the closed state, the rotating shaft 31 rotates counterclockwise, and the first limiting structure 312 does not abut against and cooperate with the second limiting structure 631. Under an action of an elastic recovery force of the elastic member 64, the second connecting rod 63 can move in a direction opposite to the x direction, and the second connecting rod 63 drives the air deflection structure 50 to move from the second position to the first position.

The elastic member 64 may be a spring, or the elastic member 64 may be any other mechanical part with elastic scalability, for example, may be a rubber member.

The rotating shaft 31 rotates, through cooperation between the first limiting structure 312 and the second limiting structure 631, to drive the second connecting rod 63 to slide in the x direction. The second end of the second connecting rod 63 may slidably cooperate with the rotating end 50c of the air deflection structure 50, and the second connecting rod 63 and the rotating end 50c slide relative to each other in the first direction (namely, the z direction). Refer to FIG. 28. When the second connecting rod 63 slides in the x direction, the second connecting rod 63 and the air deflection structure 50 slide relative to each other in the z direction. In other words, when the rotating end 50c and the second connecting rod 63 slide relative to each other in the z direction, the rotating end 50c also slides with the second connecting rod 63 in the x direction, so that the second connecting rod 63 drives the rotating end 50c of the air deflection structure 50 to rotate relative to the first housing (the second assembly frame 80). **In** this way, the air deflection structure 50 can move between the first position and the second position.

To implement sliding cooperation between the second connecting rod 63 and the air deflection structure 50, a third guide rail may be disposed on one of the second end of the second connecting rod and the rotating end, and a third sliding member may be disposed on the other one of the second end of the second connecting rod and the rotating end. For example, as shown in FIG. 29, a third sliding member 53 may be disposed on the rotating end 50c of the air deflection structure 50, a third guide rail 632 may be formed on the second end of the second connecting rod 63, and an extension direction of the third guide rail 632 is the first direction (the z direction). With reference to FIG. 28, the third sliding member 53 may be slidably disposed along the third guide rail 632, so that the rotating end 50c of the air deflection structure 50 and the second end of the second connecting rod 63 can slide relative to each other in the z direction.

The third guide rail 632 and the third sliding member 53 may be implemented in a plurality of structural forms. For example, as shown in FIG. 29, the third guide rail 632 may be a through groove provided on the second end of the second connecting rod 63. An outer side of the rotating end 50c of the air deflection structure 50 may have an extension part 55 that protrudes and extends, the third sliding member 53 may be a protrusion member formed by protrusion on the extension part 55, and the protrusion member can extend into the through groove and slide along the through groove.

Certainly, in some other examples, the second guide rail 71 and the third sliding member 53 may alternatively be any other mechanical parts that can slide relative to each other. For details, refer to the first guide rail 51 and the first sliding member 612 or the second guide rail 71 and the second sliding member 52. Details are not described in this example.

To implement sliding cooperation between the second connecting rod and the first housing, a fourth guide rail may be formed on one of the second connecting rod and the first housing, and a fourth sliding member may be formed on the other one of the second connecting rod and the first housing. For example, still as shown in FIG. 29, a fourth guide rail 633 may be formed on the second connecting rod 63, a fourth sliding member 81 may be formed on the second assembly frame 80 of the first housing 10, and an extension direction of the fourth guide rail 633 may be the x direction. With reference to FIG. 28, the fourth sliding member 81 may be slidably disposed along the fourth guide rail 633, so that the second connecting rod 63 can slide relative to the first housing 10 in the x direction.

Correspondingly, the fourth guide rail 633 and the fourth sliding member 81 may also be implemented in a plurality of structural forms. For example, as shown in FIG. 29, the fourth guide rail 633 may be a sliding groove opened on the second connecting rod 63, the fourth sliding member 81 may be a sliding block formed through protrusion on the second assembly frame 80, and the sliding block may extend into the sliding groove and slide along the sliding groove.

Certainly, in some other examples, the fourth guide rail 633 and the fourth sliding member 81 may alternatively be any other structures that can slide relative to each other. For details, refer to the first guide rail 51 and first sliding member 612 or the second guide rail 71 and second sliding member 52. Details are not described in this example.

When the first housing and the second housing rotate relative to each other, the rotating shaft 31 rotates. With reference to FIG. 28, the first limiting structure 312 on the rotating shaft 31 abuts against and cooperates with the second limiting structure 631 on the first end of the second connecting rod 63, to drive the fourth guide rail 633 and the fourth sliding member 81 to slide relative to each other, so that the second connecting rod 63 slides relative to the second assembly frame 80 in the x direction. In addition, the third guide rail 632 on the second end of the second connecting rod 63 and the third sliding member 53 on the rotating end 50c slide relative to each other in the z direction, to drive the rotating end 50c to rotate relative to the second assembly frame 80 (the first housing) around the y direction, so as to adjust the position of the air deflection structure 50.

In this example, only one end of the air deflection structure 50 may alternatively be connected to the linkage mechanism 60. Refer to FIG. 29. The electronic device may further include a fastening bracket 90. One end of the air deflection structure 50 may be connected to the linkage mechanism 60 through cooperation, and the other end of the air deflection structure 50 may movably cooperate with the fastening bracket 90.

For example, the first end of the air deflection structure 50 in the y direction may movably cooperate with the fastening bracket 90, to ensure movement stability of the two ends of the air deflection structure 50. The second end of the air deflection structure 50 in the y direction may be connected to the linkage mechanism, and stable assembly of the air deflection structure 50 is implemented via the independent fastening bracket 90. This simplifies design difficulty of the air deflection structure 50, the air exhaust structure 40, and the like, and facilitates implementation.

The two ends of the rotating end 50c in the y direction may further respectively have a first rotating shaft 56 and a second rotating shaft 57. A first mounting hole (not shown in the figure) and a second mounting hole 82 are respectively formed on the fastening bracket 90 and the second assembly frame 80, the first rotating shaft 56 may be inserted into the first mounting hole and rotate relative to the first mounting hole, and the second rotating shaft 57 may be inserted into the second mounting hole 82 and rotate relative to the second mounting hole 82, to implement rotational cooperation between the air deflection structure 50 and the first housing.

The fastening bracket 90 may further have an arc-shaped second avoidance groove 91, to avoid the air deflection structure 50 to ensure that the air deflection structure 50 can rotate around the y direction. The first end of the air deflection structure 50 may extend into the second avoidance groove 91, and the first end of the air deflection structure 50 can slide along the second avoidance groove 91.

Certainly, in some other examples, the second end of the air deflection structure 50 is fastened to the linkage mechanism 60, and the first end of the air deflection structure 50 may cooperate with another mechanical part on the first housing 10. For example, the air deflection structure 50 may be disposed across the air exhaust structure 40, and the first end of the air deflection structure 50 may movably cooperate with the air exhaust structure 40. For a specific implementation structure, refer to the foregoing descriptions. Details are not described in this example.

The air deflection structure 50 may partially extend into the airflow channel 40a of the air exhaust structure 40 (refer to FIG. 28), or the air deflection structure 50 may be located on a side that is of the airflow channel 40a and that is opposite to the rotating mechanism 30. The air deflection unit on the air deflection structure 50 may be an entire mechanical part, or there may be a plurality of air deflection units. For a specific implementation, refer to the foregoing descriptions. Details are not described in this example.

The following describes the position and a rotation manner of the air deflection structure with reference to an example of a specific state of the electronic device.

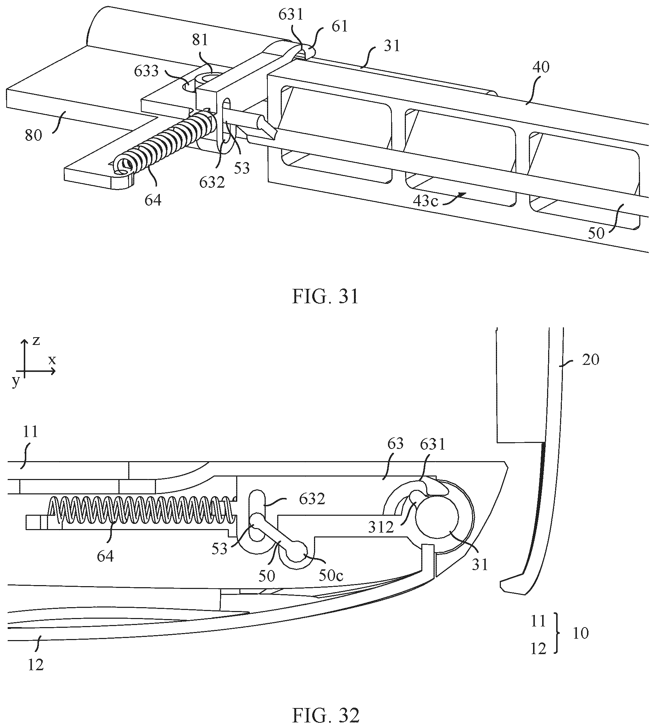

FIG. 30 is a diagram of another cross-sectional structure of the electronic device in the closed state according to an embodiment of this application. FIG. 31 is another diagram of assembly of the air deflection structure, the linkage mechanism, and the air exhaust structure in a case in which the electronic device is in the closed state according to an embodiment of this application.

When the electronic device is in the closed state, as shown in FIG. 30, for example, the angle between the first housing 10 and the second housing 20 is approximately 0°, the first limiting structure 312 on the rotating shaft 31 does not abut against and cooperate with the second limiting structure 631 on the second connecting rod 63. In this case, the air deflection structure 50 is at the first position, for example, the third sliding member 53 of the air deflection structure 50 may be located at an end that is of the third guide rail 632 and that is adjacent to the lower housing 12. With reference to FIG. 31, when the air deflection structure 50 is at the first position, the air deflection structure 50 blocks the first area of the air exhaust vent 41, and hot air can be smoothly exhausted from the lower air exhaust channel 43c.

In a process in which the electronic device is unfolded from the closed state to an intermediate state with a small angle, the rotating shaft 31 rotates, and the first limiting structure 312 may still not abut against the second limiting structure 631, so that the air deflection structure 50 remains at the first position.

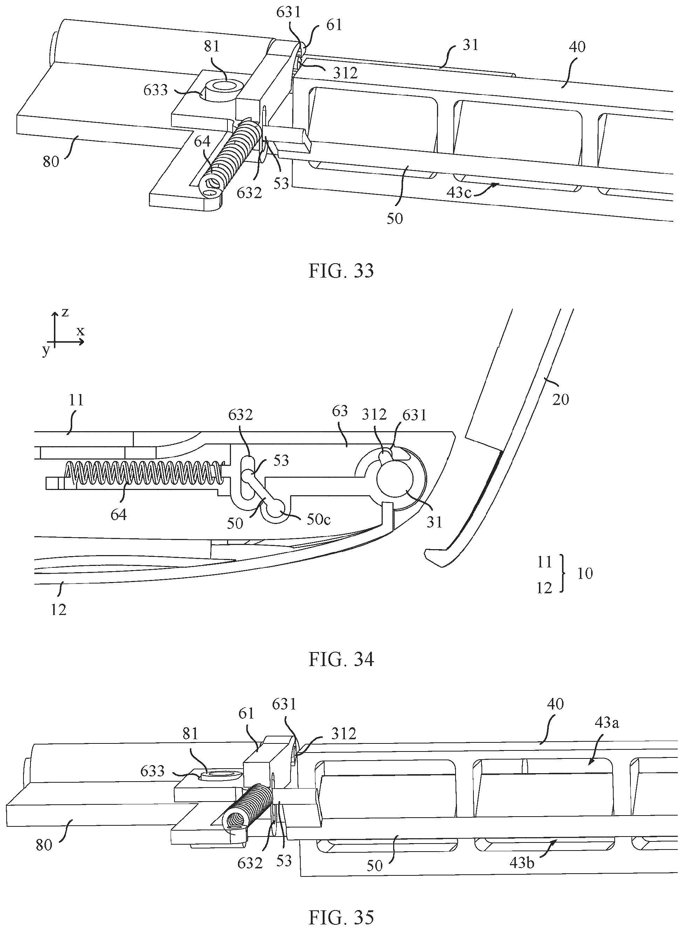

FIG. 32 is a diagram of another cross-sectional structure of the electronic device in the first intermediate state according to an embodiment of this application. FIG. 33 is another diagram of assembly of the air deflection structure, the linkage mechanism, and the air exhaust structure in a case in which the electronic device is in the first intermediate state according to an embodiment of this application.

When the electronic device is in the first intermediate state, as shown in FIG. 32, for example, the angle between the first housing 10 and the second housing 20 is approximately 90°, the air deflection structure 50 is still at the first position, and the first limiting structure 312 is about to abut against the second limiting structure 631. With reference to FIG. 33, the air deflection structure 50 blocks the first area of the air exhaust vent 41, and hot air can be smoothly exhausted from the lower air exhaust channel 43c.

When the electronic device continues to be unfolded from the first intermediate state, the rotating shaft 31 continues to rotate, and the first limiting structure 312 abuts against and cooperates with the second limiting structure 631 to drive the second connecting rod 63 to slide in the x direction, so that the third guide rail 632 on the second connecting rod 63 slides relative to the third sliding member 53 on the rotating end 50c in the z direction. In this way, the rotating end 50c of the air deflection structure 50 rotates relative to the first housing 10, and the air deflection structure 50 moves from the first position to the second position along an arc-shaped rotation track.

FIG. 34 is a diagram of another cross-sectional structure of the electronic device in the second intermediate state according to an embodiment of this application. FIG. 35 is another diagram of assembly of the air deflection structure, the linkage mechanism, and the air exhaust structure in a case in which the electronic device is in the second intermediate state according to an embodiment of this application.

For example, when the electronic device is unfolded from the first intermediate state to the second intermediate state, as shown in FIG. 34, for example, when the electronic device is in the second intermediate state, the angle between the first housing 10 and the second housing 20 is approximately 110°, the first limiting structure 312 abuts against and cooperates with the second limiting structure 631, and the air deflection structure 50 is located between the first position and the second position, for example, the third sliding member 53 of the air deflection structure 50 moves to a middle position of the third guide rail 632. With reference to FIG. 35, the air deflection structure 50 blocks the third area of the air exhaust vent 41, and hot air can be smoothly exhausted from both the upper air exhaust channel 43a and the lower air exhaust channel 43b.

In the process in which the electronic device is unfolded from the second intermediate state to the open state, the rotating shaft 31 continues to rotate to drive the air deflection structure 50 to rotate, so that the air deflection structure 50 moves to the second position along an arc-shaped track.

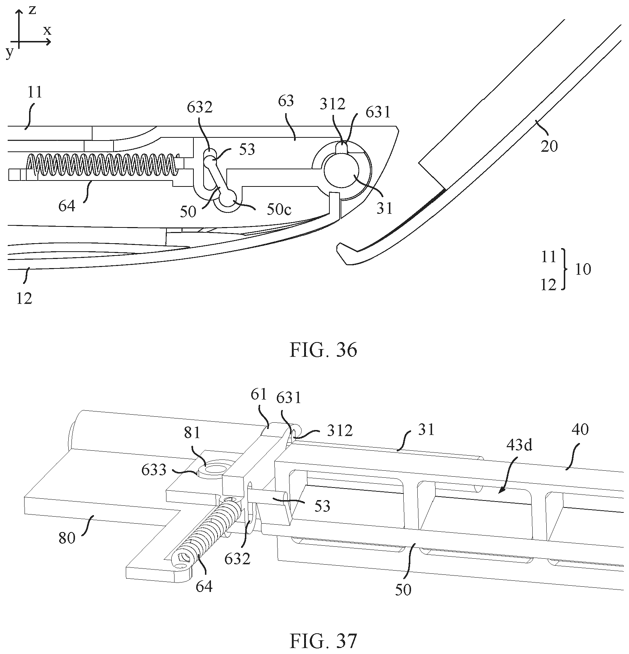

FIG. 36 is a diagram of another cross-sectional structure of the electronic device in the open state according to an embodiment of this application. FIG. 37 is another diagram of assembly of the air deflection structure, the linkage mechanism, and the air exhaust structure in a case in which the electronic device is in the open state according to an embodiment of this application.

When the electronic device is in the open state, as shown in FIG. 36, when the angle between the first housing 10 and the second housing 20 is approximately 135°, the air deflection structure 50 is at the second position, for example, the third sliding member 53 of the air deflection structure 50 may be located at one end that is of the third guide rail 632 and that is adjacent to the upper housing 11. With reference to FIG. 37, the air deflection structure 50 blocks the second area of the air exhaust vent 41, and hot air can be smoothly exhausted from the upper air exhaust channel 43d.

In the description of embodiments of this application, it should be noted that, unless otherwise explicitly stipulated and restricted, terms "mounting", "joint connection", and "connection" should be understood broadly, which, for example, may be a fixed connection, or may be an indirect connection by using a medium, or may be an internal communication between two components, or may be an interactive relationship between two components. For persons of ordinary skill in the art, specific meanings of the foregoing terms in embodiments of this application may be understood according to a specific situation. The terms such as "first", "second", "third", "fourth", and the like (if any) are intended to distinguish between similar objects but do not necessarily indicate a specific order or sequence.

Finally, it should be noted that the foregoing embodiments are merely intended to describe the technical solutions of embodiments of this application, and are not intended to limit embodiments of this application. Although embodiments of this application are described in detail with reference to the foregoing embodiments, persons of ordinary skill in the art should understand that they may still make modifications to the technical solutions described in the foregoing embodiments.

## Claims

1. A foldable electronic device (100), comprising a rotating mechanism (30), and a first housing (10) and a second housing (20) that are respectively located on two sides of the rotating mechanism (30), wherein the first housing (10) is configured to rotatably cooperate with the second housing (20) via the rotating mechanism (30) to implement unfolding and folding; and
the electronic device (100) further comprises a fan structure (120), an air exhaust structure (40), and an air deflection structure (50), wherein
the fan structure (120) is located in the first housing (10), the air exhaust structure (40) is disposed on the first housing (10), the air exhaust structure (40) has an air exhaust vent (41), and the air exhaust vent (41) faces the rotating mechanism (30);
the air deflection structure (50) is movably disposed on the first housing (10), the air deflection structure (50) is configured to block a partial area of the air exhaust vent (41), and an unblocked area of the air exhaust vent (41) is used to form an air exhaust channel; and
in a rotation process of the rotating mechanism, the air deflection structure (50) is configured to move at the air exhaust vent (41) to adjust the air exhaust channel, for the air exhaust channel to avoid the rotating mechanism (30),
**characterised in that** the electronic device (100) further comprises a linkage mechanism (60), wherein the linkage mechanism (60) is configured to cooperate with both the air deflection structure (50) and the rotating mechanism (30), and when rotating, the rotating mechanism (30) is configured to drive, via the linkage mechanism (60), the air deflection structure (50) to move.

2. The electronic device (100) according to claim 1, wherein the first housing (10) comprises an upper housing (11) and a lower housing (12), and when the electronic device (100) is in a closed state, the upper housing (11) is disposed facing the second housing (20);
when the electronic device (100) is in the closed state, the air deflection structure (50) is at a first position, the air deflection structure (50) is configured to block a first area (41a) of the air exhaust vent (41), and the first area (41a) is located on a side that is of the air exhaust vent (41) and that faces the upper housing (11);
when the electronic device (100) is in an open state, the air deflection structure (50) is at a second position, the air deflection structure (50) is configured to block a second area (41b) of the air exhaust vent (41), and the second area (41b) is located on a side that is of the air exhaust vent (41) and that faces the lower housing (12); and
in a process in which the electronic device (100) rotates from the closed state to the open state, the air deflection structure (50) is configured to move from the first position to the second position, and the air deflection structure (50) is configured to block at least a part of a third area (41c) of the air exhaust vent (41), wherein the third area (41c) is located between the first area (41a) and the second area (41b).

3. The electronic device (100) according to claim 2, wherein in a process in which the electronic device (100) rotates from the closed state to a first intermediate state, the air deflection structure (50) is always at the first position, wherein the first intermediate state is a state of the electronic device (100) in a process of switching between the closed state and the open state; and
in a process in which the electronic device (100) rotates from the first intermediate state to the open state, the air deflection structure (50) is configured to move from the first position to the second position.

4. The electronic device (100) according to claim 3, wherein the air deflection structure (50) is slidably disposed on the first housing (10), and the air deflection structure (50) is configured to slide in a first direction, for the air deflection structure (50) to move from the first position to the second position, wherein the first direction is an extension direction from the upper housing (11) to the lower housing (12).

5. The electronic device (100) according to claim 4, wherein the rotating mechanism (30) comprises a rotating shaft (31), the rotating shaft (31) is fastened to the second housing (20), and the rotating shaft (31) is configured to rotatably cooperate with the first housing (10);
the linkage mechanism (60) comprises a first connecting rod (61), a first end of the first connecting rod (61) is rotatably disposed on the first housing (10), and the first connecting rod (61) is configured to rotate around a direction parallel to an axis of the rotating mechanism (30); and
the first end of the first connecting rod (61) is configured to cooperate with the rotating shaft (31), a second end of the first connecting rod (61) is configured to cooperate with the air deflection structure (50), the rotating shaft (31) is configured to rotate to drive the first end of the first connecting rod (61) to rotate around the axis, and the second end of the first connecting rod (61) is configured to drive the air deflection structure (50) to slide in the first direction.

6. The electronic device (100) according to claim 5, wherein the second end of the first connecting rod (61) is configured to slidably cooperate with the air deflection structure (50), and the second end of the first connecting rod (61) is configured to slide relative to the air deflection structure (50) in a second direction, wherein the second direction is perpendicular to the first direction and the axis of the rotating mechanism (30); and
the first end of the first connecting rod (61) is configured to rotate, for the second end of the first connecting rod (61) and the air deflection structure (50) to slide relative to each other in the second direction, to drive the air deflection structure (50) to slide relative to the first housing (10) in the first direction.

7. The electronic device (100) according to claim 6, wherein one of the air deflection structure (50) and the first connecting rod (61) has a first guide rail (51), the other one of the air deflection structure (50) and the first connecting rod (61) has a first sliding member (612), the first guide rail (51) extends in the second direction, and the first sliding member (612) is slidably disposed along the first guide rail (51); and
one of the air deflection structure (50) and the first housing (10) has a second guide rail (71), the other one of the air deflection structure (50) and the first housing (10) has a second sliding member (52), the second guide rail (71) extends in the first direction, and the second sliding member (52) is slidably disposed along the second guide rail (71).

8. The electronic device (100) according to claim 7, wherein the first housing (10) comprises a first assembly frame (70), the rotating shaft (31) and the first connecting rod (61) are configured to separately rotatably cooperate with the first assembly frame (70), and the first assembly frame (70) has the second guide rail (71).

9. The electronic device (100) according to any one of claims 5 to 8, wherein at least a part of a periphery of the rotating shaft (31) has a first tooth structure (311), the first end of the first connecting rod (61) has a second tooth structure (611), and the first tooth structure (311) is configured to engage and cooperate with the second tooth structure (611), for the rotating shaft (31) to drive, during rotating, the first end of the first connecting rod (61) to rotate.

10. The electronic device (100) according to claim 9, wherein the first tooth structure (311) is disposed around the part of the periphery of the rotating shaft (31); and
in the process in which the electronic device (100) rotates from the first intermediate state to the open state, the first tooth structure (311) is configured to be engaged and cooperate with the second tooth structure (611).

11. The electronic device (100) according to claim 3, wherein an end part of an end of the air deflection structure (50) forms a rotating end, the rotating end is rotatably disposed on the first housing (10), and the air deflection structure (50) is rotatably disposed via the rotating end around a direction parallel to an axis of the rotating mechanism (30), for the air deflection structure (50) to move from the first position to the second position.

12. The electronic device (100) according to claim 11, wherein the rotating mechanism (30) comprises a rotating shaft (31), the rotating shaft (31) is fastened to the second housing (20), and the rotating shaft (31) rotatably is configured to cooperate with the first housing (10);
the linkage mechanism (60) comprises a second connecting rod (63), the second connecting rod (63) is slidably disposed on the first housing (10), and the second connecting rod is configured to slide in a second direction, wherein the second direction is perpendicular to the axis; and
a first end of the second connecting rod (63) is configured to cooperate with the rotating shaft (31), a second end of the second connecting rod (63) is configured to cooperate with the rotating end, the rotating shaft (31) is configured to rotate to drive the second connecting rod (63) to slide in the second direction, and the second connecting rod (63) is configured to drive the rotating end to rotate around the axis.

13. The electronic device (100) according to claim 12, wherein the rotating end is configured to slidably cooperate with the second end of the second connecting rod (63), and the rotating end is configured to slide relative to the second connecting rod (63) in a first direction, wherein the first direction is perpendicular to the second direction and the axis; and
the second connecting rod (63) is configured to slide in the second direction, for the second connecting rod (63) and the rotating end to slide relative to each other in the first direction, to drive the rotating end to rotate relative to the first housing (10).

14. The electronic device (100) according to claim 13, wherein one of the rotating end and the second connecting rod (63) has a third guide rail (632), the other one of the rotating end and the second connecting rod (63) has a third sliding member (53), the third guide rail (632) extends in the first direction, and the third sliding member (53) is slidably disposed along the third guide rail (632); and
one of the second connecting rod (63) and the first housing (10) has a fourth guide rail (633), the other one of the second connecting rod (63) and the first housing (10) has a fourth sliding member (81), the fourth guide rail (633) extends in the second direction, and the fourth sliding member (81) is slidably disposed along the fourth guide rail (633).

## Patentansprüche

1. Faltbare elektronische Vorrichtung (100), umfassend einen Drehmechanismus (30) sowie ein erstes Gehäuse (10) und ein zweites Gehäuse (20), die sich jeweils auf zwei Seiten des Drehmechanismus (30) befinden, wobei das erste Gehäuse (10) dazu konfiguriert ist, über den Drehmechanismus (30) drehbar mit dem zweiten Gehäuse (20) zusammenzuwirken, um das Auf- und Zusammenfalten zu implementieren; und
die elektronische Vorrichtung (100) ferner eine Gebläsestruktur (120), eine Luftauslassstruktur (40) und eine Luftumlenkungsstruktur (50) umfasst, wobei
sich die Gebläsestruktur (120) in dem ersten Gehäuse (10) befindet, die Luftauslassstruktur (40) auf dem ersten Gehäuse (10) angeordnet ist, die Luftauslassstruktur (40) eine Luftauslassöffnung (41) aufweist und die Luftauslassöffnung (41) dem Drehmechanismus (30) zugewandt ist;
die Luftumlenkungsstruktur (50) beweglich an dem ersten Gehäuse (10) angeordnet ist, die Luftumlenkungsstruktur (50) dazu konfiguriert ist, einen Teilbereich der Luftauslassöffnung (41) zu blockieren, und ein nicht blockierter Bereich der Luftauslassöffnung (41) verwendet wird, um einen Luftauslasskanal auszubilden; und
die Luftumlenkungsstruktur (50) in einem Drehvorgang des Drehmechanismus dazu konfiguriert, sich an der Luftauslassöffnung (41) zu bewegen, um den Luftauslasskanal einzustellen, damit der Luftauslasskanal den Drehmechanismus (30) umgeht,
**dadurch gekennzeichnet, dass**
die elektronische Vorrichtung (100) ferner einen Verbindungsmechanismus (60) umfasst, wobei der Verbindungsmechanismus (60) dazu konfiguriert ist, sowohl mit der Luftumlenkungsstruktur (50) als auch mit dem Drehmechanismus (30) zusammenzuwirken, und der Drehmechanismus (30) beim Drehen dazu konfiguriert ist, die Luftumlenkungsstruktur (50) über den Verbindungsmechanismus (60) zum Bewegen anzutreiben.

2. Elektronische Vorrichtung (100) nach Anspruch 1, wobei das erste Gehäuse (10) ein oberes Gehäuse (11) und ein unteres Gehäuse (12) umfasst, und das obere Gehäuse (11) dem zweiten Gehäuse (20) zugewandt angeordnet ist, wenn sich die elektronische Vorrichtung (100) in einem geschlossenen Zustand befindet;
wenn sich die elektronische Vorrichtung (100) in dem geschlossenen Zustand befindet, die Luftumlenkungsstruktur (50) in einer ersten Position liegt, die Luftumlenkungsstruktur (50) dazu konfiguriert ist, einen ersten Bereich (41a) der Luftauslassöffnung (41) zu blockieren, und sich der erste Bereich (41a) auf einer Seite befindet, die zu der Luftauslassöffnung (41) gehört und die dem oberen Gehäuse (11) zugewandt ist;
wenn sich die elektronische Vorrichtung (100) in einem offenen Zustand befindet, die Luftumlenkungsstruktur (50) in einer zweiten Position liegt, die Luftumlenkungsstruktur (50) dazu konfiguriert ist, einen zweiten Bereich (41b) der Luftauslassöffnung (41) zu blockieren, und sich der zweite Bereich (41b) auf einer Seite befindet, die zu der Luftauslassöffnung (41) gehört und die dem unteren Gehäuse (12) zugewandt ist; und
die Luftumlenkungsstruktur (50) in einem Vorgang, in welchem sich die elektronische Vorrichtung (100) von dem geschlossenen Zustand in den offenen Zustand dreht, dazu konfiguriert ist, sich von der ersten Position in die zweite Position zu bewegen, und die Luftumlenkungsstruktur (50) dazu konfiguriert ist, mindestens einen Teil eines dritten Bereichs (41c) der Luftauslassöffnung (41) zu blockieren, wobei sich der dritte Bereich (41c) zwischen dem ersten Bereich (41a) und dem zweiten Bereich (41b) befindet.

3. Elektronische Vorrichtung (100) nach Anspruch 2, wobei die Luftumlenkungsstruktur (50) in einem Vorgang, in welchem sich die elektronische Vorrichtung (100) von dem geschlossenen Zustand in einen ersten Zwischenzustand dreht, stets in der ersten Position liegt, wobei der erste Zwischenzustand ein Zustand der elektronischen Vorrichtung (100) in einem Vorgang des Umschaltens zwischen dem geschlossenen Zustand und dem offenen Zustand ist; und
die Luftumlenkungsstruktur (50) in einem Vorgang, in welchem die elektronische Vorrichtung (100) von dem ersten Zwischenzustand in den offenen Zustand dreht, dazu konfiguriert ist, sich von der ersten Position in die zweite Position zu bewegen.

4. Elektronische Vorrichtung (100) nach Anspruch 3, wobei die Luftumlenkungsstruktur (50) gleitend an dem ersten Gehäuse (10) angeordnet ist und die Luftumlenkungsstruktur (50) dazu konfiguriert ist, in einer ersten Richtung zu gleiten, damit sich die Luftumlenkungsstruktur (50) von der ersten Position in die zweite Position bewegt, wobei die erste Richtung eine Ausdehnungsrichtung von dem oberen Gehäuse (11) zu dem unteren Gehäuse (12) ist.

5. Elektronische Vorrichtung (100) nach Anspruch 4, wobei der Drehmechanismus (30) eine Drehwelle (31) umfasst, die Drehwelle (31) an dem zweiten Gehäuse (20) befestigt ist und die Drehwelle (31) dazu konfiguriert ist, mit dem ersten Gehäuse (10) drehbar zusammenzuwirken;
der Verbindungsmechanismus (60) eine erste Verbindungsstange (61) umfasst, ein erstes Ende der ersten Verbindungsstange (61) drehbar an dem ersten Gehäuse (10) angeordnet ist und die erste Verbindungsstange (61) dazu konfiguriert ist, sich um eine Richtung parallel zu einer Achse des Drehmechanismus (30) herum zu drehen; und
das erste Ende der ersten Verbindungsstange (61) dazu konfiguriert ist, mit der Drehwelle (31) zusammenzuwirken, ein zweites Ende der ersten Verbindungsstange (61) dazu konfiguriert ist, mit der Luftumlenkungsstruktur (50) zusammenzuwirken, die Drehwelle (31) dazu konfiguriert ist, sich zum Antreiben des ersten Endes der ersten Verbindungsstange (61) zu drehen, um sich um die Achse herum zu drehen, und das zweite Ende der ersten Verbindungsstange (61) dazu konfiguriert ist, die Luftumlenkungsstruktur (50) zum Gleiten in der ersten Richtung anzutreiben.

6. Elektronische Vorrichtung (100) nach Anspruch 5, wobei das zweite Ende der ersten Verbindungsstange (61) dazu konfiguriert ist, verschiebbar mit der Luftumlenkungsstruktur (50) zusammenzuwirken, und das zweite Ende der ersten Verbindungsstange (61) dazu konfiguriert ist, relativ zu der Luftumlenkungsstruktur (50) in einer zweiten Richtung zu gleiten, wobei die zweite Richtung senkrecht zu der ersten Richtung und der Achse des Drehmechanismus (30) verläuft; und das erste Ende der ersten Verbindungsstange (61) dazu konfiguriert ist, sich zu drehen, damit das zweite Ende der ersten Verbindungsstange (61) und die Luftumlenkungsstruktur (50) relativ zueinander in der zweiten Richtung gleiten, um die Luftumlenkungsstruktur (50) anzutreiben, relativ zu dem ersten Gehäuse (10) in der ersten Richtung zu gleiten.

7. Elektronische Vorrichtung (100) nach Anspruch 6, wobei eine von der Luftumlenkungsstruktur (50) und der ersten Verbindungsstange (61) eine erste Führungsschiene (51) aufweist, die andere von der Luftumlenkungsstruktur (50) und der ersten Verbindungsstange (61) ein erstes Gleitelement (612) aufweist, sich die erste Führungsschiene (51) in der zweiten Richtung erstreckt und das erste Gleitelement (612) entlang der ersten Führungsschiene (51) gleitend angeordnet ist; und
eines von der Luftumlenkungsstruktur (50) und dem ersten Gehäuse (10) eine zweite Führungsschiene (71) aufweist, das andere von der Luftumlenkungsstruktur (50) und dem ersten Gehäuse (10) ein zweites Gleitelement (52) aufweist, sich die zweite Führungsschiene (71) in der ersten Richtung erstreckt und das zweite Gleitelement (52) entlang der zweiten Führungsschiene (71) gleitend angeordnet ist.

8. Elektronische Vorrichtung (100) nach Anspruch 7, wobei das erste Gehäuse (10) einen ersten Baugruppenrahmen (70) umfasst, die Drehwelle (31) und die erste Verbindungsstange (61) dazu konfiguriert sind, separat drehbar mit dem ersten Baugruppenrahmen (70) zusammenzuwirken, und der erste Baugruppenrahmen (70) die zweite Führungsschiene (71) aufweist.

9. Elektronische Vorrichtung (100) nach einem der Ansprüche 5 bis 8, wobei mindestens ein Teil eines Umfangs der Drehwelle (31) eine erste Zahnstruktur (311) aufweist, das erste Ende der ersten Verbindungsstange (61) eine zweite Zahnstruktur (611) aufweist und die erste Zahnstruktur (311) dazu konfiguriert ist, in die zweite Zahnstruktur (611) einzugreifen und mit dieser zusammenzuwirken, damit die Drehwelle (31) während des Drehens das erste Ende der ersten Verbindungsstange (61) zum Drehen antreibt.

10. Elektronische Vorrichtung (100) nach Anspruch 9, wobei die erste Zahnstruktur (311) um den Teil des Umfangs der Drehwelle (31) herum angeordnet ist; und
die erste Zahnstruktur (311) in dem Vorgang, in welchem sich elektronische Vorrichtung (100) von dem ersten Zwischenzustand in den offenen Zustand dreht, dazu konfiguriert ist, mit der zweiten Zahnstruktur (611) in Eingriff zu kommen und mit dieser zusammenzuwirken.

11. Elektronische Vorrichtung (100) nach Anspruch 3, wobei ein Endteil eines Endes der Luftumlenkungsstruktur (50) ein Drehende ausbildet, das Drehende drehbar an dem ersten Gehäuse (10) angeordnet ist und die Luftumlenkungsstruktur (50) über das Drehende um eine Richtung parallel zu einer Achse des Drehmechanismus (30) herum drehbar angeordnet ist, damit sich die Luftumlenkungsstruktur (50) von der ersten Position zu der zweiten Position bewegt.

12. Elektronische Vorrichtung (100) nach Anspruch 11, wobei der Drehmechanismus (30) eine Drehwelle (31) umfasst, die Drehwelle (31) an dem zweiten Gehäuse (20) befestigt ist und die Drehwelle (31) drehbar dazu konfiguriert ist, mit dem ersten Gehäuse (10) zusammenzuwirken;
der Verbindungsmechanismus (60) eine zweite Verbindungsstange (63) umfasst, die zweite Verbindungsstange (63) gleitend an dem ersten Gehäuse (10) angeordnet ist und die zweite Verbindungsstange dazu konfiguriert ist, in einer zweiten Richtung zu gleiten, wobei die zweite Richtung senkrecht zu der Achse verläuft; und
ein erstes Ende der zweiten Verbindungsstange (63) dazu konfiguriert ist, mit der Drehwelle (31) zusammenzuwirken, ein zweites Ende der zweiten Verbindungsstange (63) dazu konfiguriert ist, mit dem Drehende zusammenzuwirken, die Drehwelle (31) dazu konfiguriert ist, sich zum Antreiben der zweiten Verbindungsstange (63) zu drehen, um in der zweiten Richtung zu gleiten, und die zweite Verbindungsstange (63) dazu konfiguriert ist, das Drehende zum Drehen um die Achse herum anzutreiben.

13. Elektronische Vorrichtung (100) nach Anspruch 12, wobei das Drehende dazu konfiguriert ist, gleitend mit dem zweiten Ende der zweiten Verbindungsstange (63) zusammenzuwirken, und das Drehende dazu konfiguriert ist, relativ zu der zweiten Verbindungsstange (63) in einer ersten Richtung zu gleiten, wobei die erste Richtung senkrecht zu der zweiten Richtung und der Achse verläuft; und
die zweite Verbindungsstange (63) dazu konfiguriert ist, in der zweiten Richtung zu gleiten, damit die zweite Verbindungsstange (63) und das Drehende relativ zueinander in der ersten Richtung gleiten, um das Drehende zum Drehen relativ zu dem ersten Gehäuse (10) anzutreiben.

14. Elektronische Vorrichtung (100) nach Anspruch 13, wobei eines von dem Drehende und der zweiten Verbindungsstange (63) eine dritte Führungsschiene (632) aufweist, das andere von dem Drehende und der zweiten Verbindungsstange (63) ein drittes Gleitelement (53) aufweist, sich die dritte Führungsschiene (632) in der ersten Richtung erstreckt und das dritte Gleitelement (53) gleitend entlang der dritten Führungsschiene (632) angeordnet ist; und
eines von der zweiten Verbindungsstange (63) und dem ersten Gehäuse (10) eine vierte Führungsschiene (633) aufweist, das andere von der zweiten Verbindungsstange (63) und dem ersten Gehäuse (10) ein viertes Gleitelement (81) aufweist, sich die vierte Führungsschiene (633) in der zweiten Richtung erstreckt und das vierte Gleitelement (81) gleitend entlang der vierten Führungsschiene (633) angeordnet ist.

## Revendications

1. Dispositif électronique pliable (100), comprenant un mécanisme de rotation (30), et un premier boîtier (10) et un second boîtier (20) qui sont situés respectivement sur deux côtés du mécanisme de rotation (30), dans lequel le premier boîtier (10) est configuré pour coopérer de manière rotative avec le second boîtier (20) via le mécanisme de rotation (30) pour mettre en œuvre le dépliage et le pliage ; et
le dispositif électronique (100) comprend en outre une structure de ventilateur (120), une structure d'évacuation d'air (40) et une structure de déviation d'air (50), dans lequel
la structure de ventilateur (120) est située dans le premier boîtier (10), la structure d'évacuation d'air (40) est disposée sur le premier boîtier (10), la structure d'évacuation d'air (40) a un évent d'évacuation d'air (41), et l'évent d'évacuation d'air (41) fait face au mécanisme de rotation (30) ;
la structure de déviation d'air (50) est disposée de manière mobile sur le premier boîtier (10), la structure de déviation d'air (50) est configurée pour bloquer une zone partielle de l'évent d'évacuation d'air (41), et une zone non bloquée de l'évent d'évacuation d'air (41) est utilisée pour former un canal d'évacuation d'air ; et
dans un processus de rotation du mécanisme de rotation, la structure de déviation d'air (50) est configurée pour se déplacer au niveau de l'évent d'évacuation d'air (41) pour régler le canal d'échappement d'air, pour que le canal d'échappement d'air évite le mécanisme de rotation (30), **caractérisé en ce que**
le dispositif électronique (100) comprend en outre un mécanisme de liaison (60), dans lequel le mécanisme de liaison (60) est configuré pour coopérer à la fois avec la structure de déviation d'air (50) et le mécanisme de rotation (30), et lors de la rotation, le mécanisme de rotation (30) est configuré pour entraîner, via le mécanisme de liaison (60), le déplacement de la structure de déviation d'air (50).

2. Dispositif électronique (100) selon la revendication 1, dans lequel le premier boîtier (10) comprend un boîtier supérieur (11) et un boîtier inférieur (12), et lorsque le dispositif électronique (100) est dans un état fermé, le boîtier supérieur (11) est disposé face au second boîtier (20) ;
lorsque le dispositif électronique (100) est dans l'état fermé, la structure de déviation d'air (50) est dans une première position, la structure de déviation d'air (50) est configurée pour bloquer une première zone (41a) de l'évent d'évacuation d'air (41), et la première zone (41a) est située sur un côté qui est de l'évent d'évacuation d'air (41) et qui fait face au boîtier supérieur (11) ;
lorsque le dispositif électronique (100) est dans un état ouvert, la structure de déviation d'air (50) est dans une seconde position, la structure de déviation d'air (50) est configurée pour bloquer une seconde zone (41b) de l'évent d'évacuation d'air (41), et la seconde zone (41b) est située sur un côté qui est de l'évent d'évacuation d'air (41) et qui fait face au boîtier inférieur (12) ; et
dans un processus dans lequel le dispositif électronique (100) tourne de l'état fermé à l'état ouvert, la structure de déviation d'air (50) est configurée pour se déplacer de la première position à la seconde position, et la structure de déviation d'air (50) est configurée pour bloquer au moins une partie d'une troisième zone (41c) de l'évent d'évacuation d'air (41), dans lequel la troisième zone (41c) est située entre la première zone (41a) et la deuxième zone (41b).

3. Dispositif électronique (100) selon la revendication 2, dans lequel, dans un processus dans lequel le dispositif électronique (100) tourne de l'état fermé à un premier état intermédiaire, la structure de déviation d'air (50) est toujours dans la première position, dans lequel le premier état intermédiaire est un état du dispositif électronique (100) dans un processus de commutation entre l'état fermé et l'état ouvert ; et
dans un processus dans lequel le dispositif électronique (100) tourne du premier état intermédiaire à l'état ouvert, la structure de déviation d'air (50) est configurée pour passer de la première position à la seconde position.

4. Dispositif électronique (100) selon la revendication 3, dans lequel la structure de déviation d'air (50) est disposée de manière coulissante sur le premier boîtier (10), et la structure de déviation d'air (50) est configurée pour coulisser dans une première direction, pour que la structure de déviation d'air (50) se déplace de la première position à la seconde position, dans lequel la première direction est une direction d'extension du boîtier supérieur (11) au boîtier inférieur (12).

5. Dispositif électronique (100) selon la revendication 4, dans lequel le mécanisme de rotation (30) comprend un arbre rotatif (31), l'arbre rotatif (31) est fixé au second boîtier (20), et l'arbre rotatif (31) est configuré pour coopérer de manière rotative avec le premier boîtier (10) ;
le mécanisme de liaison (60) comprend une première bielle (61), une première extrémité de la première bielle (61) est disposée de manière rotative sur le premier boîtier (10), et la première bielle (61) est configurée pour tourner autour d'une direction parallèle à un axe du mécanisme de rotation (30) ; et
la première extrémité de la première bielle (61) est configurée pour coopérer avec l'arbre rotatif (31), une seconde extrémité de la première bielle (61) est configurée pour coopérer avec la structure de déviation d'air (50), l'arbre rotatif (31) est configuré pour tourner afin d'entraîner la rotation de la première extrémité de la première bielle (61) autour de l'axe, et la seconde extrémité de la première bielle (61) est configurée pour entraîner le coulissement de la structure de déviation d'air (50) dans la première direction.

6. Dispositif électronique (100) selon la revendication 5, dans lequel la seconde extrémité de la première bielle (61) est configurée pour coopérer de manière coulissante avec la structure de déviation d'air (50), et la seconde extrémité de la première bielle (61) est configurée pour coulisser par rapport à la structure de déviation d'air (50) dans une seconde direction, dans lequel la seconde direction est perpendiculaire à la première direction et à l'axe du mécanisme de rotation (30) ; et
la première extrémité de la première bielle (61) est configurée pour tourner, pour que la seconde extrémité de la première bielle (61) et la structure de déviation d'air (50) coulissent l'une par rapport à l'autre dans la seconde direction, pour entraîner le coulissement de la structure de déviation d'air (50) par rapport au premier boîtier (10) dans la première direction.

7. Dispositif électronique (100) selon la revendication 6, dans lequel l'une de la structure de déviation d'air (50) et de la première bielle (61) a un premier rail de guidage (51), l'autre de la structure de déviation d'air (50) et de la première bielle (61) a un premier élément coulissant (612), le premier rail de guidage (51) s'étend dans la seconde direction, et le premier élément coulissant (612) est disposé de manière coulissante le long du premier rail de guidage (51) ; et
l'un de la structure de déviation d'air (50) et du premier boîtier (10) a un deuxième rail de guidage (71), l'autre de la structure de déviation d'air (50) et du premier boîtier (10) a un deuxième élément coulissant (52), le deuxième rail de guidage (71) s'étend dans la première direction et le deuxième élément coulissant (52) est disposé de manière coulissante le long du deuxième rail de guidage (71).

8. Dispositif électronique (100) selon la revendication 7, dans lequel le premier boîtier (10) comprend un premier cadre d'assemblage (70), l'arbre rotatif (31) et la première bielle (61) sont configurés pour coopérer séparément de manière rotative avec le premier cadre d'assemblage (70), et le premier cadre d'assemblage (70) a le deuxième rail de guidage (71).

9. Dispositif électronique (100) selon l'une quelconque des revendications 5 à 8, dans lequel au moins une partie d'une périphérie de l'arbre rotatif (31) a une première structure dentée (311), la première extrémité de la première bielle (61) a une seconde structure dentée (611), et la première structure dentée (311) est configurée pour venir en prise et coopérer avec la seconde structure dentée (611), pour que l'arbre rotatif (31) entraîne, pendant la rotation, la rotation de la première extrémité de la première bielle (61).

10. Dispositif électronique (100) selon la revendication 9, dans lequel la première structure dentée (311) est disposée autour de la partie de la périphérie de l'arbre rotatif (31) ; et
dans le processus dans lequel le dispositif électronique (100) tourne du premier état intermédiaire à l'état ouvert, la première structure dentée (311) est configurée pour venir en prise et coopérer avec la seconde structure dentée (611).

11. Dispositif électronique (100) selon la revendication 3, dans lequel une partie d'extrémité d'une extrémité de la structure de déviation d'air (50) forme une extrémité rotative, l'extrémité rotative est disposée de manière rotative sur le premier boîtier (10), et la structure de déviation d'air (50) est disposée de manière rotative via l'extrémité rotative autour d'une direction parallèle à un axe du mécanisme de rotation (30), pour que la structure de déviation d'air (50) se déplace de la première position à la seconde position.

12. Dispositif électronique (100) selon la revendication 11, dans lequel le mécanisme de rotation (30) comprend un arbre rotatif (31), l'arbre rotatif (31) est fixé au second boîtier (20), et l'arbre rotatif (31) est configuré pour coopérer de manière rotative avec le premier boîtier (10) ;
le mécanisme de liaison (60) comprend une seconde bielle (63), la seconde bielle (63) est disposée de manière coulissante sur le premier boîtier (10), et la seconde bielle est configurée pour coulisser dans une seconde direction, dans lequel la seconde direction est perpendiculaire à l'axe ; et
une première extrémité de la seconde bielle (63) est configurée pour coopérer avec l'arbre rotatif (31), une seconde extrémité de la seconde bielle (63) est configurée pour coopérer avec l'extrémité rotative, l'arbre rotatif (31) est configuré pour tourner pour entraîner le coulissement de la seconde bielle (63) dans la seconde direction, et la seconde bielle (63) est configurée pour entraîner la rotation de l'extrémité rotative autour de l'axe.

13. Dispositif électronique (100) selon la revendication 12, dans lequel l'extrémité rotative est configurée pour coopérer de manière coulissante avec la seconde extrémité de la seconde bielle (63), et l'extrémité rotative est configurée pour coulisser par rapport à la seconde bielle (63) dans une première direction, dans lequel la première direction est perpendiculaire à la seconde direction et à l'axe ; et
la seconde bielle (63) est configurée pour coulisser dans la seconde direction, pour que la seconde bielle (63) et l'extrémité rotative coulissent l'une par rapport à l'autre dans la première direction, pour entraîner la rotation de l'extrémité rotative par rapport au premier boîtier (10).

14. Dispositif électronique (100) selon la revendication 13, dans lequel l'une de l'extrémité rotative et de la seconde bielle (63) a un troisième rail de guidage (632), l'autre de l'extrémité rotative et de la seconde bielle (63) a un troisième élément coulissant (53), le troisième rail de guidage (632) s'étend dans la première direction, et le troisième élément coulissant (53) est disposé de manière coulissante le long du troisième rail de guidage (632) ; et
l'un de la seconde bielle (63) et du premier boîtier (10) a un quatrième rail de guidage (633), l'autre de la seconde bielle (63) et du premier boîtier (10) a un quatrième élément coulissant (81), le quatrième rail de guidage (633) s'étend dans la seconde direction et le quatrième élément coulissant (81) est disposé de manière coulissante le long du quatrième rail de guidage (633).
